# EUROPEAN PATENT APPLICATION

(11) **EP 4 397 784 A1**
(43) Date of publication of application: **10.07.2024**
(21) Application number: 22863574.4
(22) Date of filing: 01.09.2022
(51) Int. Cl.: C23C 16/458, C23C 16/455

(54) **THIN FILM DEPOSITION DEVICE, THIN FILM DEPOSITION METHOD, AND THIN FILM DEPOSITION APPARATUS**

(30) Priority: 02.09.2021 CN 202111027306
(71) Applicant: ACM Research (Shanghai) Inc., Shanghai 201203 (CN); ACM Research Korea Co., Ltd., Icheon-si, Gyeonggi-do (KR); Cleanchip Technologies Limited, Hong Kong (HK)
(72) Inventor: WANG, Hui, Shanghai 201203 (CN); ZHANG, Shan, Shanghai 201203 (CN); WANG, Jun, Shanghai 201203 (CN); ZHANG, Xiaoyan, Shanghai 201203 (CN); JIA, Shena, Shanghai 201203 (CN); SHEN, Hui, Shanghai 201203 (CN); WANG, Jian, Shanghai 201203 (CN); KIM, Tom, Icheon-si, Gyeonggi-do (KR); LEE, Jacob, Icheon-si, Gyeonggi-do (KR); BAEK, William, Icheon-si, Gyeonggi-do (KR); KIM, Zeus, Icheon-si, Gyeonggi-do (KR); KIM, Yy, Icheon-si, Gyeonggi-do (KR)
(74) Representative: Osha BWB
(86) International application number: PCT/CN2022/116482
(87) International publication number: WO 2023/030439

(57) **Abstract**

Disclosed in the invention is a thin film deposition a device, comprising: a processing chamber; a gas supply assembly, which is arranged on the top wall of the processing chamber; a heating tray, which is arranged below the gas supply assembly for bearing and heating the substrate; a radio frequency source; and a rotating mechanism configured to control the rotation of the substrate, or the rotation of the heating tray, or control the synchronous rotation of the substrate and the heating tray, wherein the rotation shaft for rotation is perpendicular to and passing through the substrate. The radio frequency source is kept in an on state during rotation. According to the method, non-uniformity of the thickness of the thin film deposited on the substrate is compensated, and the uniformity and stability of deposition of the thin film of the PECVD layer stack structure are achieved, and the phenomenon that etching through holes of the thin film deposited on the substrate deviate from the vertical direction in the subsequent etching process is avoided. Therefore, the stability of the performance of a semiconductor device is further guaranteed.

## Description

### Background

### Field

The invention relates to the technical field of semiconductor manufacturing, in particular to a thin film deposition device, a thin film deposition method and a thin film deposition apparatus.

### Description of the Related Art

In a plasma-enhanced chemical vapor deposition (PECVD) vacuum process chamber, a layer stack of different materials is deposited on a substrate. Wherein, the substrate is placed in the vacuum processing chamber, firstly the first processing gas is introduced to form the first layer of the first material on the substrate; then plasma cleaning and gas cleaning are performed, and then the second process gas is introduced to form the second layer of the second material on the substrate. The above-mentioned plasma cleaning and gas cleaning are repeated, and the first material and the second material are stacked and deposited on the substrate to form a thin film with layers stack structure. Wherein, three-dimensional (3D) storage can be made from layers stack of alternating thin-film materials deposited on a substrate.

At present, 3D storage uses alternating layers of oxide and nitride films to achieve the purpose of storing data in a three-dimensional structure through related processes. These stacked structures may include multiple layers of the first material and the second material, such as a continuous stack of more than 300 or even 500 layers.

Specifically, in some cases, the stack structure of the first material and the second material in the thin film material of the 3D storage stack may be oxide and silicon, silicon and doped silicon, or silicon and nitride. Correspondingly, most of the thin film materials of these materials combinations for 3D storage stacks can be applied to BiCS (Bit-Cost Scalable), TCAT (Terabit Unit Array Transistor) or other 3D storage structures. In addition, the stack structure of the first material and the second material may also be other material compositions, and the sequence of depositing the first material and the second material layer on the substrate may also be reversed.

However, the existing PECVD apparatus has the following problems:
1. As the number of stacked layers on the surface of the substrate increases, the thickness of the film increases accordingly, which directly leads to the deterioration of the uniformity between the layers of the film and the uniformity of the total film after stacking, which in turn leads to the vertical structure cannot be obtained during the etching process subsequently, which limits the continuous increase of the number of film layers in the film stacking process.
   Under the current existing apparatus conditions, when the deposited film exceeds 200 layers, the uniformity and quality of the film will be degraded, and the deviation of the fixed position will continue to be enlarged during the continuous stacking process of different types of films, which will cause the uniformity of the substrate film to deviate from a controllable range. The control range makes the subsequent etching process unable to achieve the accuracy of through hole etching, resulting in the deviation of the etched through hole from the vertical direction during the etching process, which further leads to the failure of the semiconductor device.
2. The deformation generated by the long-term use of the gas shower head or the extraction of exhaust gas by the external air pump leads to uneven distribution of the process gas supplied by the gas supply assembly, which leads to the deviation of the film thickness during the film deposition process, which in turn leads to the etching through hole deviates from the vertical direction during the etching process, which further leads to the failure of the semiconductor device.
3. When depositing thin films in the traditional PECVD method, the heating tray needs to be fixed to ensure the flatness of the heating tray. However, when the heating tray is fixed, the temperature distribution of the substrate will form a fixed pattern, which leads to uneven heating of the substrate which leads the etching through hole deviates from the vertical direction during the etching process, which further leads to failure of the semiconductor device.

To sum up, it is necessary to propose a new thin film deposition device and its method to solve the above problems.

### Summary

In view of the above-mentioned shortcomings of the prior art, the purpose of the present invention is to provide a thin film deposition device, a thin film deposition method and a thin film deposition apparatus, which are configured to solve the problem of poor uniformity of the deposited thin film on the substrate in the prior art.

To achieve the above purpose and other related purposes, the present invention provides a thin film deposition device, comprising: a processing chamber configured for thin film deposition; a gas supply assembly arranged on the top wall of the processing chamber for supplying process gas to the processing chamber; a heating tray arranged below the gas supply assembly for bearing and heating the substrate; a radio frequency source for providing radio frequency power to activate the process gas in the processing chamber to dissociate into plasma and deposit a thin film on the substrate; a rotating mechanism for controlling the rotation of the substrate, or the rotation of the heating tray, or the synchronous rotation of the substrate and the heating tray, the rotation shaft of the rotation member being perpendicular to the substrate and passing through the substrate; wherein the radio frequency source is kept in an on state during the rotating mechanism rotating the substrate, or the heating tray, or the substrate and the heating tray.

The present invention also provides a thin film deposition device, comprising: a processing chamber configured for thin film deposition; a gas supply assembly arranged on the top wall of the processing chamber for supplying process gas to the processing chamber; a heating tray arranged below the gas supply assembly for bearing and heating a substrate; a radio frequency source for providing radio frequency power to activate the process gas in the processing chamber to dissociate into plasma and deposit a thin film on the substrate; a rotating mechanism for controlling the rotation of the substrate, the rotation shaft of the rotating mechanism being perpendicular to substrate and passing through the substrate; a supporting member for supporting the substrate; a lifting member connected to the supporting member for driving the supporting member to rise or fall in the vertical direction to lift the substrate away from the heating tray or place the substrate on the heating tray; wherein the rotating mechanism is arranged at the bottom of the lifting member, and configured for driving the supporting member and the lifting member to rotate synchronously along the horizontal circumferential direction to rotate the substrate.

The present invention also provides a thin film deposition device, comprising: a processing chamber configured for thin film deposition; a gas supply assembly arranged on the top wall of the processing chamber for supplying process gas to the processing chamber; a heating tray arranged below the gas supply assembly for bearing and heating the substrate; a radio frequency source for providing radio frequency power to activate the process gas in the processing chamber to dissociate into plasma and deposit a thin film on the substrate; a rotating mechanism for controlling the rotation of the substrate, the rotation shaft of the rotating mechanism being perpendicular to the substrate and passing through the substrate; a supporting member for supporting the substrate, the supporting member including an ejector pin and a supporting ring; a first lifting member connected to the ejector pin for driving the ejector pin to rise or fall vertically to load or unload the substrate; a second lifting member connected to the supporting ring for driving the supporting ring to rise or fall in the vertical direction to lift the substrate away from the heating tray or place the substrate on the heating tray; wherein the rotating mechanism is arranged at the bottom of the second lifting member and configured for driving the supporting ring and the second lifting member to rotate to rotate the substrate, and the heating tray is provided with a first through hole, and the ejector pin is arranged in the first through hole.

The present invention also provides a thin film deposition device, including: a processing chamber configured for thin film deposition; a gas supply assembly arranged on the top wall of the processing chamber for supplying process gas to the processing chamber; a heating tray arranged below the gas supply assembly for bearing and heating the substrate; a radio frequency source for providing radio frequency power to activate the process gas in the processing chamber to dissociate into plasma and deposit a thin film on the substrate; a rotating mechanism for controlling the synchronous rotation of the substrate and the heating tray, the rotation shaft of the rotating mechanism being perpendicular to the substrate and passing through the substrate; wherein the rotating mechanism is connected to the heating tray and configured for driving the heating tray to rotate around the center shaft of the substrate as the shaft of rotation to rotate the substrate synchronously.

The present invention also provides a thin film deposition device, comprising: a processing chamber configured for thin film deposition; a gas supply assembly arranged on the top wall of the processing chamber for supplying process gas to the processing chamber; a heating tray arranged below the gas supply assembly for bearing and heating a substrate; a radio frequency source for providing radio frequency power to activate the process gas in the processing chamber to dissociate into plasma and deposit a thin film on the substrate; a rotating mechanism for controlling the rotation of the heating tray, the rotation shaft of the rotating mechanism being perpendicular to the substrate and passing through the substrate; a supporting member for supporting the substrate; a lifting member connected to the supporting member and configured for driving the supporting member to rise or fall in the vertical direction to lift the substrate away from the heating tray or place the substrate on the heating tray; wherein the rotating mechanism is connected to the heating tray and configured for driving the heating tray to rotate around the center shaft of the substrate as the shaft of rotation.

The present invention also provides a thin film deposition device, comprising: a processing chamber configured for thin film deposition; a gas supply assembly arranged on the top wall of the processing chamber for supplying process gas to the processing chamber; a heating tray arranged below the gas supply assembly for bearing and heating a substrate; a radio frequency source for providing radio frequency power to activate the process gas in the processing chamber to dissociate into plasma and deposit a thin film on the substrate; a rotating mechanism for controlling the rotation of the heating tray, the rotation shaft of the rotating mechanism is perpendicular to the substrate and passing through the substrate; a supporting member for supporting the substrate; a lifting member connected to the heating tray and configured for driving the heating tray to rise or fall; wherein the rotating mechanism is connected to the lifting member and configured for driving the lifting member and the heating tray to rotate around the center shaft of the substrate as the shaft of rotation.

The present invention also provides a thin film deposition device, comprising: a processing chamber configured for thin film deposition; a gas supply assembly arranged on the top wall of the processing chamber for supplying process gas to the processing chamber; a heating tray arranged below the gas supply assembly for bearing and heating the substrate; a radio frequency source for providing radio frequency power to activate the process gas in the processing chamber to dissociate into plasma and deposit a thin film on the substrate; a rotating mechanism connected to the heating tray and configured for controlling the rotation of the heating tray, the rotation shaft of the rotating mechanism being perpendicular to the substrate and passing through the substrate; a first lifting member connected to the rotating mechanism and configured for driving the rotating mechanism and the heating tray to rise or fall; a second lifting member connected to the supporting member and the first lifting member respectively for driving the supporting member and the first lifting member to rise or fall in vertical direction.

The present invention also provides a thin film deposition device, comprising: a processing chamber configured for thin film deposition; a gas supply assembly arranged on the top wall of the processing chamber and for supplying process gas to the processing chamber; a heating tray arranged below the gas supply assembly for bearing and heating a substrate; a radio frequency source for providing radio frequency power to activate the process gas in the processing chamber to dissociate into plasma and deposit a thin film on the substrate; a rotating mechanism for controlling the rotation of the substrate, the rotation shaft of the rotating mechanism being perpendicular to the substrate and passing through the substrate; a lifting member connected to the heating tray and configured for driving the heating tray to rise or fall in vertical direction; a supporting member for supporting the substrate; wherein the rotating mechanism drives the supporting member to rotate synchronously with the substrate.

The present invention also provides a thin film deposition device, comprising: a processing chamber configured for thin film deposition; a gas supply assembly arranged on the top wall of the processing chamber for supplying process gas to the processing chamber; a heating tray arranged below the gas supply assembly for bearing and heating a substrate; a radio frequency source for providing radio frequency power to activate the process gas in the processing chamber to dissociate into plasma and deposit a thin film on the substrate; the rotating mechanism connected to the gas supply assembly for driving the gas supply assembly to rotate.

The present invention also provides a thin film deposition device, comprising: a processing chamber configured for thin film deposition; a gas supply assembly arranged on the top wall of the processing chamber and for supplying process gas to the processing chamber; a heating tray arranged below the gas supply assembly for bearing and heating a substrate; a radio frequency source for providing radio frequency power to activate the process gas in the processing chamber to dissociate into plasma and deposit a thin film on the substrate; a rotating mechanism connected to the heating tray for driving the heating tray to rotate around the center shaft of the substrate as the shaft of rotation to rotate the substrate synchronously; when the rotating mechanism drives the heating tray to drive the substrate to rotate synchronously, the radio frequency source is adjusted to be off.

The present invention also provides a thin film deposition device, comprising: a processing chamber configured for thin film deposition; a gas supply assembly arranged on the top wall of the processing chamber for supplying process gas to the processing chamber; a heating tray arranged below the gas supply assembly for bearing and heating a substrate; a radio frequency source for providing radio frequency power to activate the process gas in the processing chamber to dissociate into plasma and deposit a thin film on the substrate; a supporting member for supporting the substrate; a lifting member connected to the supporting member for driving the supporting member to rise or fall in the vertical direction to lift the substrate away from the heating tray or place the substrate on the heating tray; a rotating mechanism connected to the heating tray for driving the heating tray to rotate around the center shaft of the substrate as the shaft of rotation to rotate the substrate synchronously; when the rotating mechanism drives the heating tray to drive the substrate to rotate synchronously, the radio frequency source is adjusted to be off.

The present invention also provides a thin film deposition apparatus, comprising: a processing chamber configured for thin film deposition; a gas supply assembly arranged on the top wall of the processing chamber for supplying process gas to the processing chamber; a heating tray arranged below the gas supply assembly for bearing and heating the substrate; a radio frequency source for providing radio frequency power to activate the process gas in the processing chamber to dissociate into plasma and deposit a thin film on the substrate; a lifting member connected to the gas supply assembly for driving the gas supply assembly to rise or fall.

The present invention also provides a thin film deposition device, comprising: a processing chamber configured for thin film deposition; a gas supply assembly having a first porous plate arranged on the top wall of the processing chamber for supplying process gas to the processing chamber; a heating tray arranged below the gas supply assembly for bearing and heating a substrate; a gas regulating unit arranged in the gas supply assembly having a second porous plate which is arranged opposite to the first porous plate of the gas supply assembly, the gap between the second porous plate and the first porous plate being adjustable.

The present invention also provides a thin film deposition method, comprising the following steps: S1, placing the substrate in the processing chamber and evacuating the processing chamber; S2, introducing process gas into the processing chamber and turning on the radio frequency source to deposit a certain number of layers of thin films on the substrate; S3, stopping to introduce the process gas and introducing non-process gas to maintain the pressure in the processing chamber; S4, keeping the radio frequency source in an on state, rotating the substrate or the heating tray or the substrate and the heating tray synchronously by a set angle; S5, introducing process gas into the processing chamber again and re-depositing a certain number of layers of thin films on the substrate; S6, stopping to introduce the process gas and introducing non-process gas to maintain the pressure in the processing chamber; S7, determining whether the number of layers of the film deposited on the substrate meets the requirements; if not, going back to step S2; if yes, executing step S8; S8, taking out the substrate from the processing chamber.

The present invention also provides a thin film deposition method, comprising the following steps: S11, placing the substrate in the processing chamber and evacuating the processing chamber; S12, introducing the process gas into the processing chamber and turning on the radio frequency source to deposit a certain film thickness of thin film on the substrate; S13, introducing the process gas, keeping the radio frequency source in an on state, rotating the substrate or the heating tray or the substrate and the heating tray synchronously by a set angle; S14, depositing a thin film on the substrate; S15, determining whether the thickness of the deposited film on the substrate meets the requirements, if not, going back to step S12; if yes, executing step S16; S16, taking out the substrate from the processing chamber.

The present invention also provides a thin film deposition method, comprising the following steps: S21, placing the substrate in the processing chamber, and evacuating the processing chamber; S22, introducing process gas into the processing chamber and turning on the radio frequency source to deposit a certain number of layers of thin films on the substrate; S23, stopping to introduce the process gas and introducing non-process gas to maintain the pressure in the processing chamber; S24, adjusting the radio frequency source to be off state, so that the heating tray rotates the substrate synchronously by a set angle; S25, introducing process gas into the processing chamber, and adjusting the radio frequency source to be on to deposit a certain number of layers of thin films on the substrate; S26, stopping to introduce the process gas and introducing non-process gas to maintain the pressure in the processing chamber; S27, determining whether the number of layers of the film deposited on the substrate meets the requirements; if not, going back to step S22; if yes, executing step S28; S28, taking out the substrate from the processing chamber.

The present invention also provides a thin film deposition method, comprising the following steps: S31, placing the substrate in the processing chamber and evacuating the processing chamber; S32, introducing process gas into the processing chamber and turning on the radio frequency source to deposit a certain number of layers of thin films on the substrate; S33, stopping to introduce the process gas and introducing non-process gas to maintain the pressure in the processing chamber; S34, adjusting the radio frequency source to be off state, lifting the substrate to rotate the heating tray at a set angle, and then placing the substrate back on the heating tray; S35, introducing process gas into the processing chamber and adjusting the radio frequency source to be on state to deposit a certain number of layers of thin films on the substrate; S36, stopping to introduce the process gas and introducing non-process gas to maintain the pressure in the processing chamber; S37, determining whether the number of layers of the deposited thin film on the substrate meets the requirements; if not, going back to step S32; if yes, executing step S38; S38, taking out the substrate from the processing chamber.

The present invention also provides a thin film deposition method, comprising the following steps: S41, placing a multiple of substrates in sequence in the processing chamber to complete the thin film deposition process; S42, rotating the gas supply assembly by a set angle; S43, cleaning the processing chamber, and going back to S41 after the processing chamber is purified.

The present invention also provides a thin film deposition method, comprising the following steps: S51, placing multiple substrates in sequence in the processing chamber to complete the thin film deposition process; S52, adjusting the gap between a second porous plate of a gas regulating unit and a first porous plate of a gas supply assembly; S53, cleaning the processing chamber, and after the processing chamber is purified going back to step S51.

The present invention also provides a thin film deposition device, comprising: a processing chamber configured for thin film deposition; a gas supply assembly arranged on the top wall of the processing chamber for supplying process gas to the processing chamber; a heating tray arranged below the gas supply assembly for bearing and heating the substrate; a radio frequency source for providing radio frequency power to activate the process gas in the processing chamber to dissociate into plasma and deposit a thin film on the substrate; an ejector pin arranged in the heating tray, one end of the ejector pin being arranged at the bottom of the processing chamber, the other end of the ejector pin being configured to receive the substrate; wherein the processing chamber is provided with multiple heating trays and multiple sets of ejector pins, and the heights of the multiple sets of ejector pins are different.

The present invention also provides a thin film deposition apparatus, comprising: a substrate loading port for placing substrates; a buffer device; a front-end robot for transferring the substrate between the substrate load port and the buffer device; the thin film deposition device configured for thin film deposition on the substrate according to any one of devices mentioned above; a process manipulator for transferring the substrate between the buffer device and the processing chamber of the thin film deposition device.

Using this invention, the problem of poor uniformity of the deposited film when the substrate is deposited super multi-layers (for example, >200 layers) is solved. When the number of layers deposited by the film exceeds 200 layers, the uniformity and stability of the film deposition of the PECVD layer stack structure is realized. The phenomenon that the thin film deposited on the substrate deviates from the vertical direction during the subsequent etching process is avoided, thereby the stability of the performance of the semiconductor device is ensured.

### Description of the drawings

FIG. 1A illustrates a schematic of the tilting of a multi-layer thin film deposited by the existing PECVD thin film deposition technology.
FIG. 2A and FIG. 2B illustrate a substrate of the thin film deposition device before and after being lifted up respectively according to the embodiment 1 of the present invention.
FIG. 3A and FIG. 3B illustrate a top view before and after the ejector pin rotation a set angle respectively according to the embodiment 1 of the present invention.
FIG. 4A and FIG. 4B illustrate a substrate of the thin film deposition device before and after being lifted up respectively according to the embodiment 5 of the present invention.
FIG. 5 illustrates a top view of the supporting ring according to the embodiment 5 of the present invention.
FIG. 6A and FIG. 6B illustrate a substrate of the thin film deposition device before and after being lifted up respectively according to the embodiment 6 of the present invention.
FIG. 7 illustrates a top view of the ejector pin and the supporting ring according to the embodiment 6 of the present invention.
FIG. 8A to FIG. 8D illustrate schematics of different set angles of rotation of the substrate according to the present invention.
FIG. 9 illustrates a structural schematic of the thin film deposition device according to the embodiment 7 and the embodiment 10 of the present invention.
FIG. 10 illustrates a structural schematic of the thin film deposition device according to the embodiment 8 and the embodiment 11 of the present invention.
FIG. 11 illustrates a structural schematic of the thin film deposition device according to the embodiment 9 of the present invention.
FIG. 12A illustrates a schematic of the uneven deposition of the film caused by the non-uniform distribution of the gas supplied by the gas supply assembly in the existing PECVD thin film deposition technology.
FIG. 12B illustrates a schematic of the non-uniformity of the deposited film caused by exhaust gas drawn by the air pump in the existing PECVD thin film deposition technology.
FIG. 13A illustrates a structural schematic of the thin film deposition device according to the embodiment 9 of the present invention.
FIG. 13B to FIG. 13C illustrate schematics of stretching or shrinking the side walls of the gas regulating unit respectively according to the embodiment 12 of the present invention.
FIG. 14A illustrates a structural schematic of the thin film deposition device according to the embodiment 13 of the present invention.
FIG. 14B to FIG. 14C illustrate schematics of stretching or shrinking the telescopic respectively according to the embodiment 13 of the present invention.
FIG. 15A to FIG. 15B illustrate schematics of the thin film deposition method respectively according to the embodiment 14 of the present invention.
FIG. 16 illustrates a flow diagram of the thin film deposition method according to the embodiment 18 of the present invention.
FIG. 17 illustrates a flow diagram of the thin film deposition method according to the embodiment 19 of the present invention.
FIG. 18 illustrates a flow diagram of the film deposition method according to the embodiment 20 of the present invention.
FIG. 19 illustrates a flow diagram of the thin film deposition method according to the embodiment 21 of the present invention.
FIG. 20A to FIG. 20K illustrate schematics of the arrangement of thin film deposition apparatus respectively according to the embodiment 22 and the embodiment 23 of the present invention.
FIG. 21 illustrates a structural schematic of the thin film deposition device according to the embodiment 25 of the present invention.
FIG. 22-23 illustrate structural schematics of the thin film deposition device according to the embodiment 26 of the present invention.
FIG. 24-25 illustrate schematics of the thin film deposition device according to the embodiment 27 of the present invention.
FIG. 26-27 illustrate structural schematics of the thin film deposition device according to the embodiment 28 of the present invention.
FIG. 28-29 illustrate structural schematics of the thin film deposition device according to the embodiment 29 of the present invention.
FIG. 30-31 illustrate structural schematics of the thin film deposition device according to the embodiment 30 of the present invention.
FIG. 32-33 illustrate structural schematics of the thin film deposition device according to embodiment 31 of the present invention.
FIG. 34 illustrates the connection relationship between the controller and each member according to the present invention.
FIG. 35-36 illustrate structural schematics of the thin film deposition device according to the embodiment 32 of the present invention.
FIG. 37 illustrates a structural schematic of the arrangement of multiple sets of ejector pins according to the embodiment 33 of the present invention.

### Detailed description

Embodiments of the present invention are described below through specific examples, and those skilled in the art can easily understand other advantages and effects of the present invention from the content disclosed in this specification. The present invention can also be implemented or applied through other different specific implementation modes, and various modifications or changes can be made to the details in this specification based on different viewpoints and applications without departing from the spirit of the present invention.

It will be understood that when an element is referred to as being "on," "connected to," "coupled to" or " in contact with " another element, it can be directly on the other element. On, connected or coupled to, or in contact with, the other element, or there may be an intervening element. In contrast, when an element is referred to as being "directly on," "directly connected to," "directly coupled to" or "directly in contact with " another element, there are no intervening elements present.

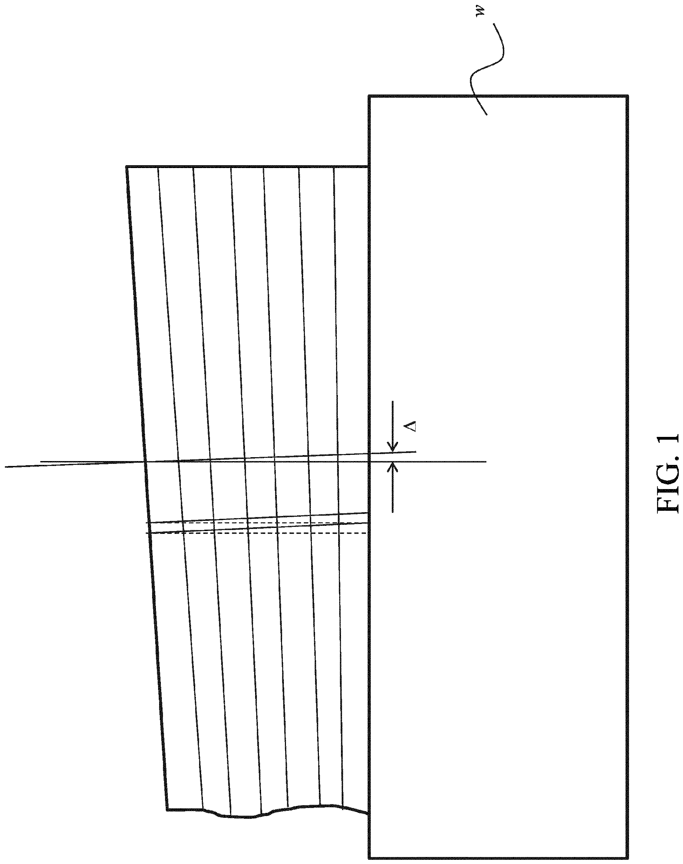

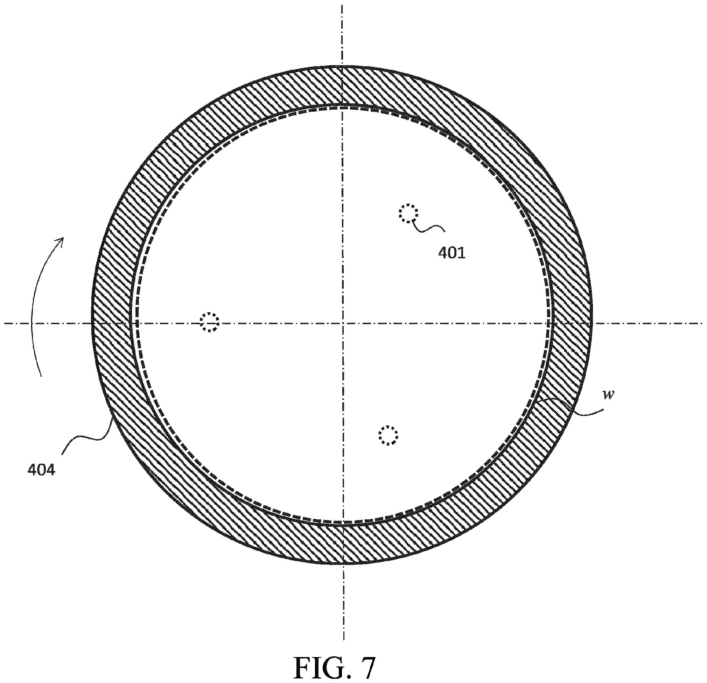

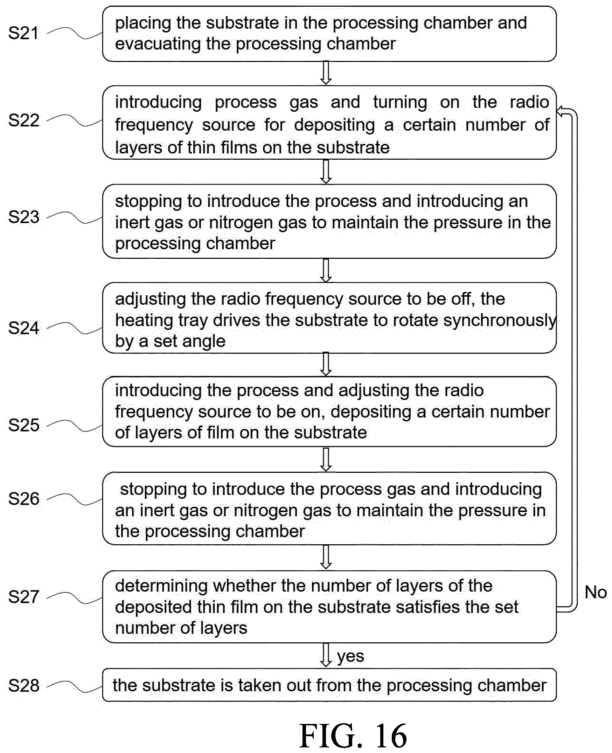

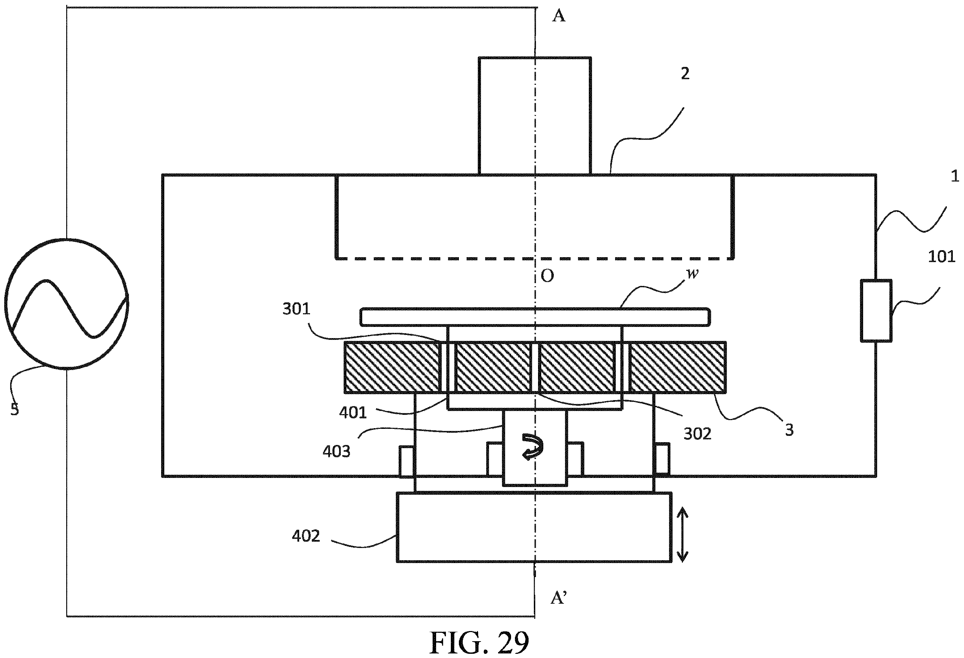

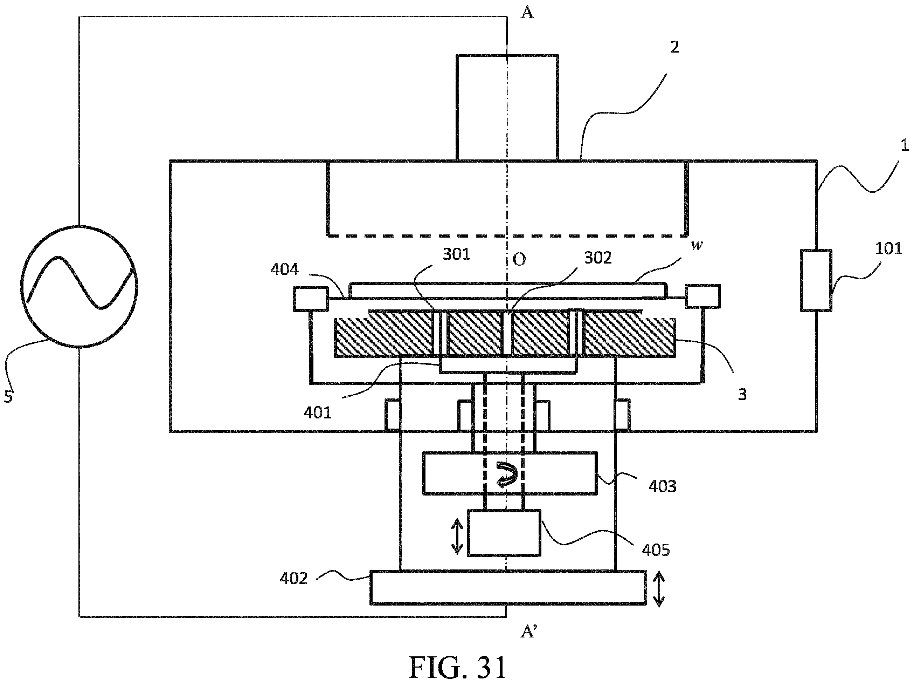

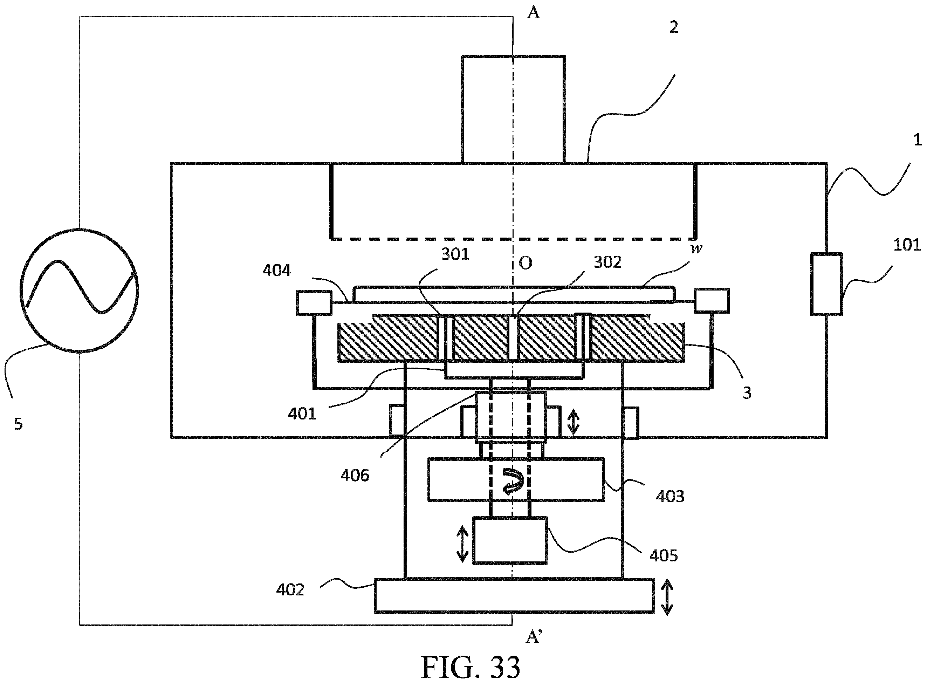

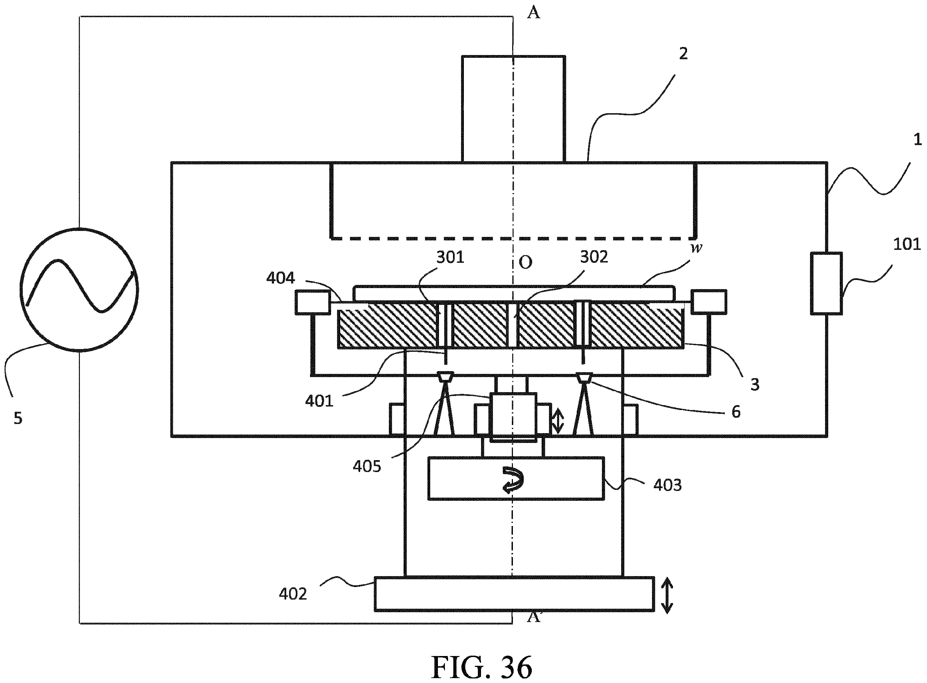

Referring to FIG. 1 to FIG. 37, it should be noted that the diagrams provided in this embodiment are only schematically illustrating the basic concept of the present invention, although the diagrams only show assembly related to the present invention rather than the number and shape of assembly in actual implementation and size drawing, the shape, quantity and proportion of each assembly can be changed arbitrarily during actual implementation, and the layout of the assembly may also be more complicated.

### Embodiment one

As the flatness of the substrate on the heating tray is different due to the uneven temperature distribution of the heating tray or the stress on the substrate, the uniformity of the film becomes worse during the film deposition process. When different thin films are alternately deposited on the substrate, the thickness of the thin film of the layer stack structure formed on the substrate w increases with the number of layers that the first material and the second material alternately stacked on the substrate w increases. As shown in FIG. 1, above problems results in a tilt of the stacked films by an angle Δ. As the number of layers of these layer stack structures increases, the uniformity of the stacked film is deteriorated that causing the uniformity of the film on the substrate w to deviate from the controllable range, and the subsequent etching process cannot achieve the accuracy of through-hole etching that causing the deviation of the etched through hole from the vertical direction during the etching process, which further leads to the failure of the semiconductor device.

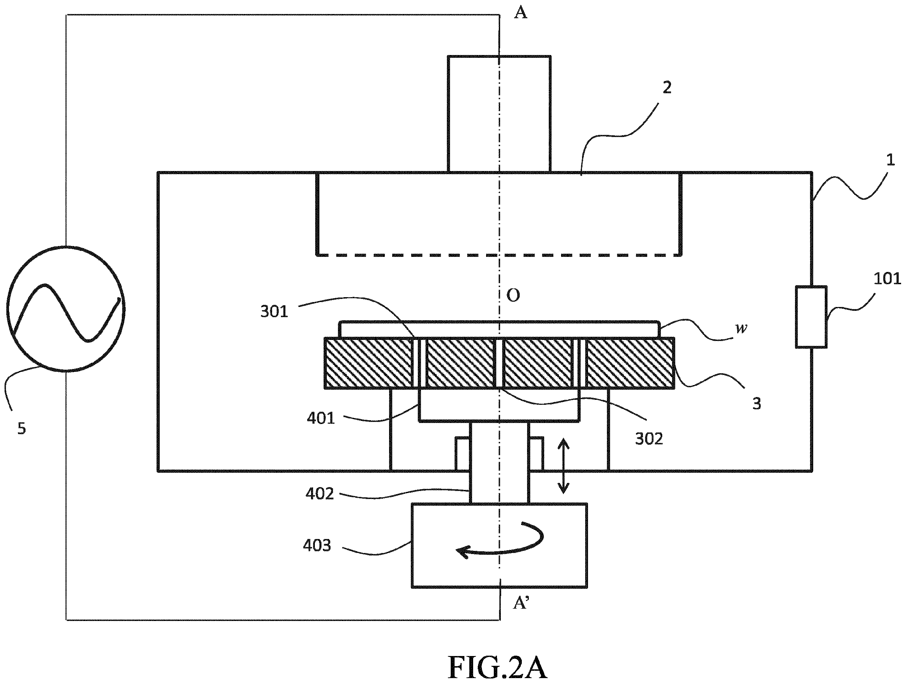

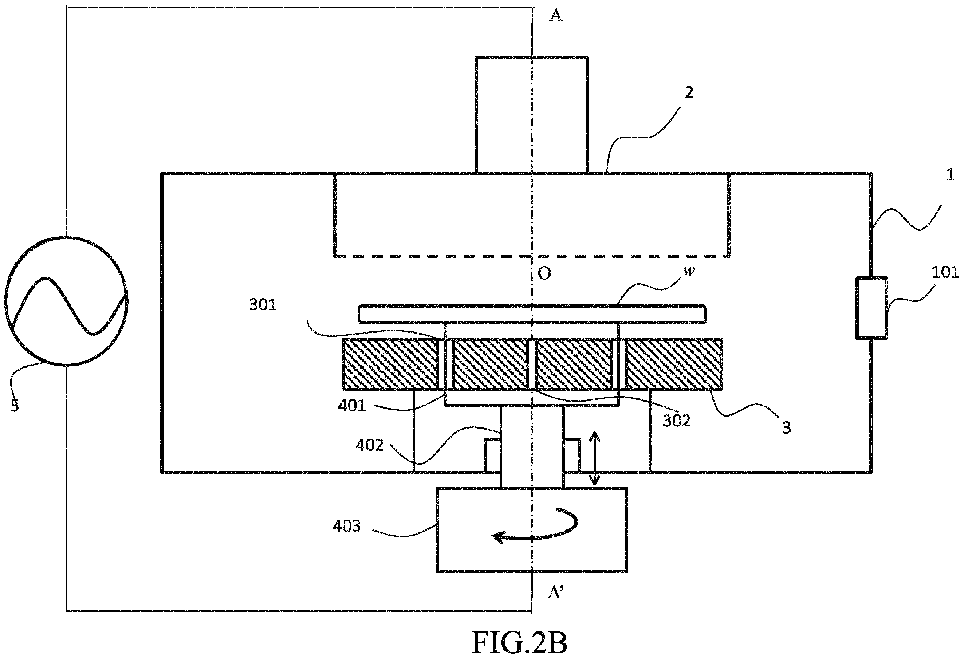

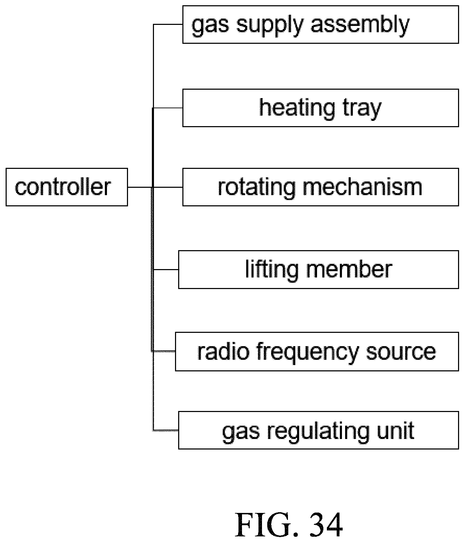

In order to solve the above problems, the embodiment 1 provides a thin film deposition device. Specifically, referring to FIG. 2A , FIG. 2B and FIG. 34, the thin film deposition device includes: a processing chamber 1 configured for thin film deposition; a gas supply assembly 2 arranged on the top wall of the processing chamber 1 for supplying process gas to the processing chamber 1; a heating tray 3 arranged below the gas supply assembly 2 for bearing and heating the substrate w; the radio frequency source 5 for providing radio frequency power to form a radio frequency electric field in the processing chamber 1 to activate the process gas in the processing chamber 1 to dissociate into plasma and deposit thin film on the substrate w; the rotating mechanism 403 for controlling the rotation of the substrate w around the rotation shaft AA' that vertical and passing through the substrate w; a controller connected to the gas supply assembly 2, the radio frequency source 5, the heating tray 3, and the rotating mechanism 403 respectively for controlling the operation of the gas supply assembly 2, the radio frequency source 5, the heating tray 3, and the rotating mechanism 403. The controller is also configured for building a program menu that includes keeping the radio frequency source 5 in an on state when the substrate w is rotating. In the present embodiment, the rotation shaft AA' of the rotation passes through the center O of the substrate w, so that the substrate w rotates around the rotation shaft AA'.

When the rotating mechanism 403 rotates the substrate w, stopping to introduce the process gas and introducing inert gas or nitrogen gas into the processing chamber 1 to maintain the pressure in the processing chamber 1 and keeping the radio frequency source 5 in an on state. Because some impurity particles are suspended in the processing chamber 1 after depositing a certain number of layers of film on the substrate w. At this time, keeping the radio frequency source 5 in an on state that the processing chamber 1 is filled with a radio frequency electric field, and the impurity particles are charged under the action of the internal radio frequency electric field in the processing chamber 1. The charged impurity particles remain suspended and will not fall on the surface of the substrate w, which effectively prevents the impurity particles from falling on the thin film deposited on the substrate w and avoids contaminating the thin film deposited on the substrate w.

The embodiment 1 proposes to keep the radio frequency source 5 in an on state while driving the substrate to rotate to compensate for the uneven thickness of the film deposited on the substrate w. The embodiment realizes the uniformity and stability of the film deposition of the PECVD layer stack structure and avoids the phenomenon that the thin film deposited on the substrate w deviates from the vertical direction during the subsequent etching process, thereby further ensuring the stability of the performance of the semiconductor device.

As shown in FIG. 2A and FIG. 2B, the thin film deposition apparatus further includes: a supporting member for supporting the substrate w; a lifting member 402 connected to the supporting member for driving the supporting member to rise or fall in the vertical direction to lift the substrate w away from the heating tray 3 or to place the substrate w on the heating tray 3. The lifting member 402 is connected to the controller to control the lifting member 402 to work.

In the embodiment 1, the rotating mechanism 403 is arranged at the bottom of the lifting member 402 for driving the supporting member and the lifting member 402 to rotate synchronously along the horizontal circumferential direction to rotate the substrate w.

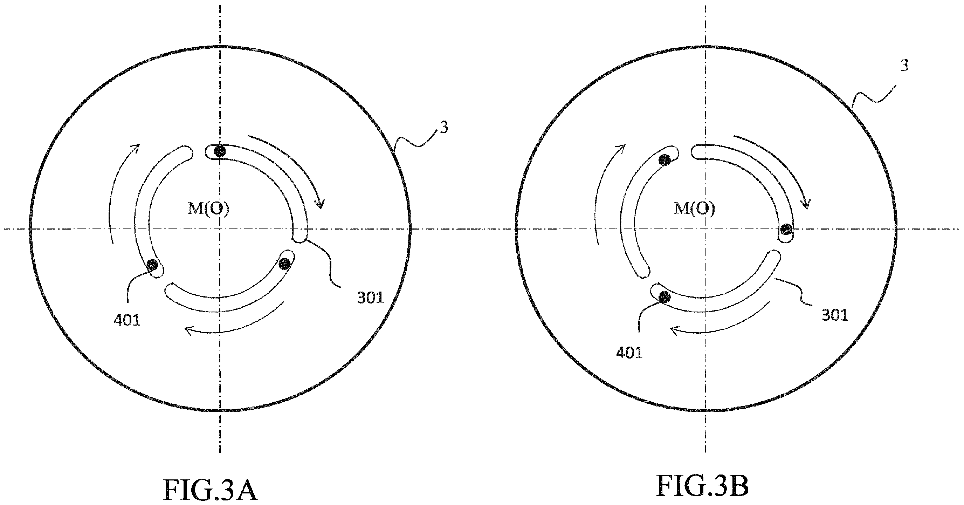

In the embodiment 1, the supporting member is an ejector pin 401 that can move in the vertical direction and in the horizontal circumferential direction. The heating tray 3 is provided with a first through hole 301, and the ejector pin 401 is arranged in the first through hole 301. As shown in FIG. 3A and FIG. 3B, the cross-section of the first through hole 301 on the horizontal plane is arc-shaped or circular, and the center M of the arc-shaped or circular shape is on a vertical line with the center O of the substrate w.

In the embodiment 1, the lifting member 402 is a cylinder 402, and the cylinder 402 is connected to the bottom of the ejector pin 401. The rotating mechanism 403 is a motor 403, and the motor 403 is connected to the bottom of the cylinder 402. The cylinder 402 drives the ejector pin 401 to rise or fall, and the motor 403 rotates the cylinder 402 and the ejector pin 401 synchronously.

When the substrate w needs to be rotated, as shown in FIG. 2B, the lifting member 402 drives the ejector pin 401 to rise vertically and protrudes from the first through hole 301, and the ejector pin 401 lifts the substrate w to make the substrate w detached from the heating tray 3. Then the rotating mechanism 403 drives the ejector pin 401 to move along the arc track in the first through hole 301 to rotate the substrate w at a set angle, as shown in FIG. 3A and FIG. 3B. After the substrate w rotates at a set angle, the substrate w stops rotating. The lifting member 402 drives the ejector pin 401 to move downward in the vertical direction, and the substrate w is placed on the heating tray 3 for subsequent thin film deposition.

The number of the ejector pins 401 is at least three, and the number of the first through holes 301 is at least three correspondingly. The first through holes correspond to the ejector pins 401 one by one. In the embodiment 1, as shown in FIG. 3A and FIG. 3B, the number of the ejector pins 401 is three. The number of the first through holes 301 is three, and the cross sections of the three first through holes 301 in the horizontal plane are three arcs.

In the embodiment 1, at least three ejector pins 401 are configured for lifting the substrate w to rotate the substrate w at a set angle to compensate for the uneven thickness of the film deposited on the substrate w. The embodiment realizes the uniform deposition of the PECVD layer stack structure film and stability and avoids the phenomenon that the thin film deposited on the substrate w deviates from the vertical direction during the subsequent etching process, thereby further ensuring the stability of the performance of the semiconductor device.

A door 101 is provided on the side wall of the processing chamber 1 for entering the processing chamber 1 before and after the thin film deposition process on the substrate w to place or remove the substrate w from the heating tray 3.

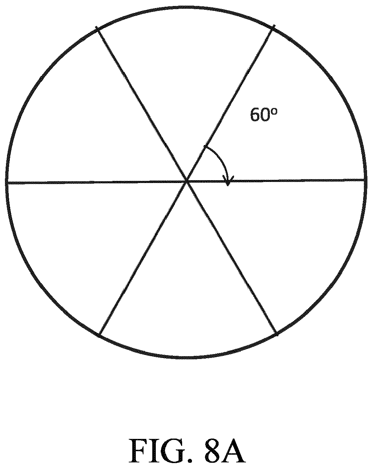

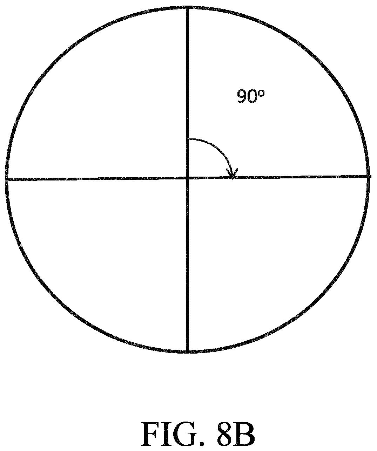

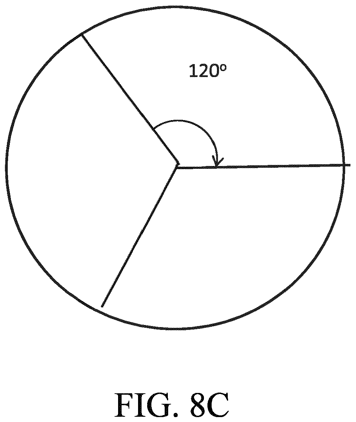

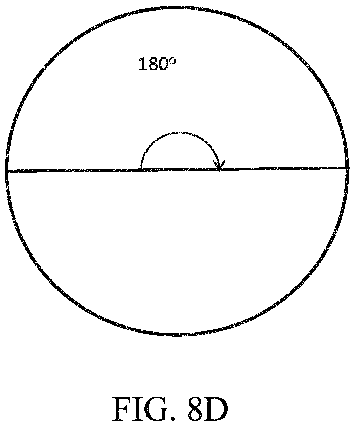

After the thin film deposition is completed, (the substrate w rotation times+1) *the setting angle of each time of substrate w rotation=360°. In the embodiment 1, as shown in FIG. 8A to FIG. 8D, after the film deposition is completed, the number of the rotations of the substrate w is 5, and the setting angle of each rotation is 60 degrees. It is also possible that the number of the rotations of the substrate w is 3, and the setting angle of each rotation is 90 degrees. It is also possible that the number of the rotations of the substrate w is 2, and the setting angle of each rotation is 120 degrees. It is also possible that the number of the rotations of the substrate w is 1, and the setting angle of each rotation is 180 degrees.

The deposition rate of the thin film on the substrate w is related to the multiple of the radio frequency power of the radio frequency source 5. The high frequency of the radio frequency source 5 is an integer multiple n of 13.56MHz, where n=1,2,3,..,8 . The low frequency range of the radio frequency source 5 is 20KHz-400KHz.

However, keeping the radio frequency source 5 in an on state while the substrate is rotating will cause the gap between the back of the substrate w and the heating tray 3 is too large after the substrate w is separated from the heating tray 3, which will lead to arc discharge easily. In order to avoid the substrate w from the heating tray 3 arc discharge phenomenon when the radio frequency source 5 is in an on state, as shown in FIG. 2A and FIG. 2B, it is necessary to adjust the gap between the substrate w and the heating tray 3 to be smaller than the set value. In the embodiment 1, the set value of the gap between the substrate w and the heating tray 3 is m, where 0<m ≦ 5 mm. Therefore, under the condition that the gap between the substrate w and the heating tray 3 is smaller than the set value, the radio frequency source 5 is kept in an on state to reduce the risk of arc discharge on the substrate w and ensure the safety and stability of the thin film deposition process.

### Embodiment two

Embodiment 2 provides a thin film deposition device, compared with the embodiment 1, the difference is:

As shown in FIG. 2A and FIG. 2B, the heating tray 3 is provided with a second through hole 302. Keeping the radio frequency source 5 in an on state while the substrate is rotating and introducing the non-process gas into the gap between the substrate w and the heating tray 3 through the second through hole 302 to reduce the risk of arc discharge when the substrate w is detached from the heating tray 3. The non-process gas is inert gas or nitrogen in an embodiment.

After depositing a certain number of layers of film on the substrate w, some impurity particles are suspended in the processing chamber 1. At this time, keeping the radio frequency source 5 in an on state and filling the processing chamber 1 with a radio frequency electric field, the impurity particles are charged under the action of the internal radio frequency electric field in the processing chamber 1. The charged impurity particles remain suspended and will not fall on the surface of the substrate w to prevent the impurity particles from falling on the thin film deposited on the substrate w effectively to avoid contamination of the thin film deposited on the substrate w. Therefore, when the gap between the substrate w and the heating tray 3 is filled with non-process gas, the radio frequency source 5 is kept in an on state to reduce the risk of arc discharge on the substrate w and ensure the safety and stability of the thin film deposition process.

Other settings in this embodiment are the same as those in the embodiment 1, and will not be repeated here.

### Embodiment three

Embodiment 3 provides a thin film deposition device, compared with the embodiment 1, the difference is:

Keeping the radio frequency source 5 in an on state while the substrate is rotating, and the radio frequency power of the radio frequency source 5 is adjusted to be smaller than it was during the film deposition process. It reduces the risk of arc discharge when the substrate w is separated from the heating tray 3 and ensure the safety and stability of the thin film deposition process.

Other settings in this embodiment are the same as those in embodiment 1, and will not be repeated here.

### Embodiment Four

Embodiment 4 provides a thin film deposition device, compared with the embodiment 1, the difference is:

Before the substrate w is rotated, the radio frequency source 5 is adjusted to be off and purify the processing chamber 1.

After depositing a certain number of layers of film on the substrate w, the processing chamber 1 will have impurity particles. The dirtier the processing chamber 1, the more likely arc discharge will occur when the substrate w is separated from the heating tray 3 in the processing chamber 1. Preferably, the radio frequency source 5 is turned off before the substrate w is rotated, and nitrogen gas is supplied to the processing chamber 1 through the gas supply assembly 2 to purify the processing chamber 1.

Other settings in this embodiment are the same as those in the embodiment 1, and will not be repeated here.

### Embodiment five

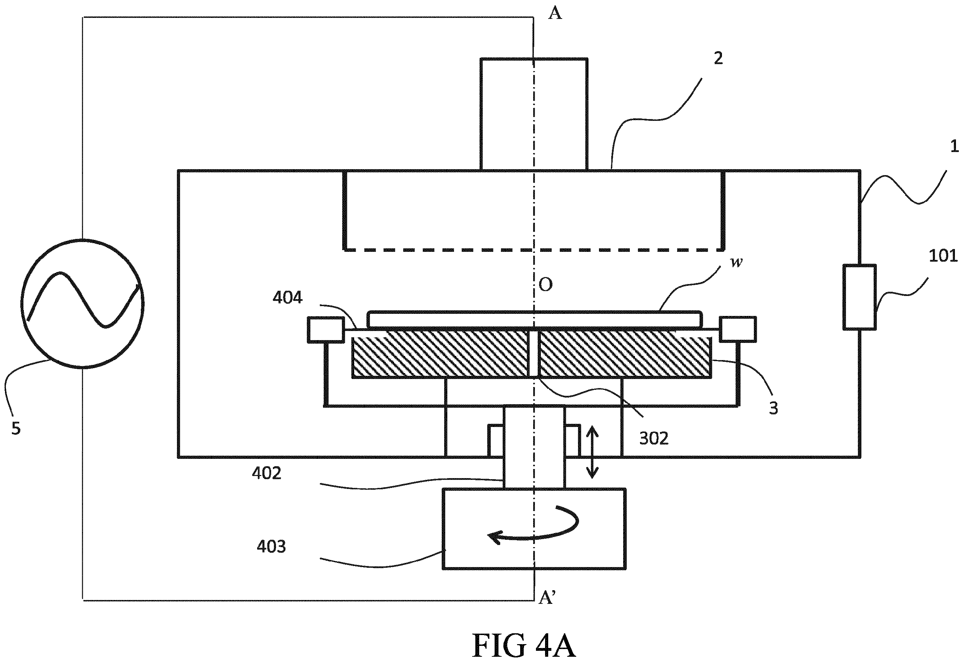

As shown in FIG. 4A to FIG. 5, embodiment 5 provides a thin film deposition device, compared with the embodiment 1, the difference is:

The supporting member is a supporting ring 404arranged at the bottom of the edge of the substrate w, and the supporting ring 404 can be raised or fall in the vertical direction and rotated around the center line AA' of the substrate w as the rotation shaft.

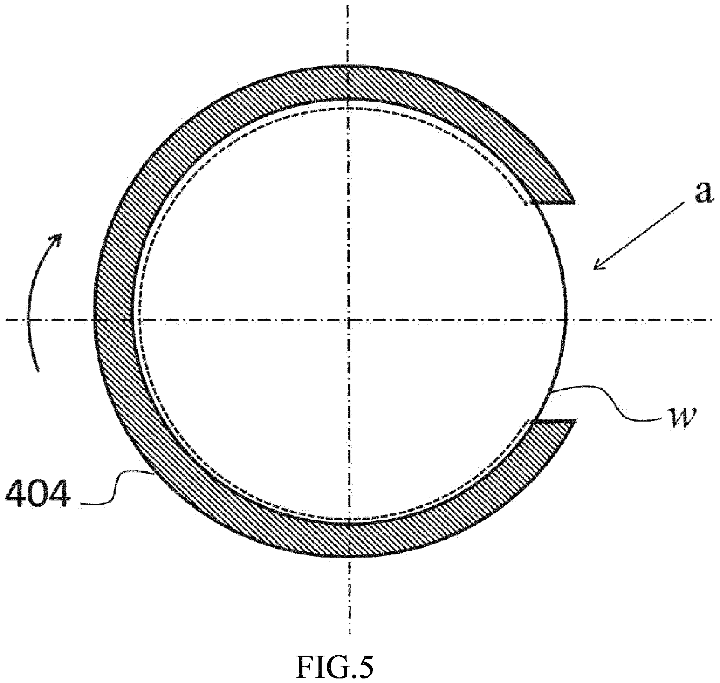

As shown in FIG. 5, the supporting ring 404 is a circular ring with a notch a, or the supporting ring 404 includes multiple arc-shaped structures of a ring. Correspondingly, a door 101 is provided on the side wall of the processing chamber 1 configured for the manipulators to enter the processing chamber 1 before and after the thin film deposition process on the substrate w to place the substrate w on the supporting ring 404 or remove the substrate w from the supporting ring 404.

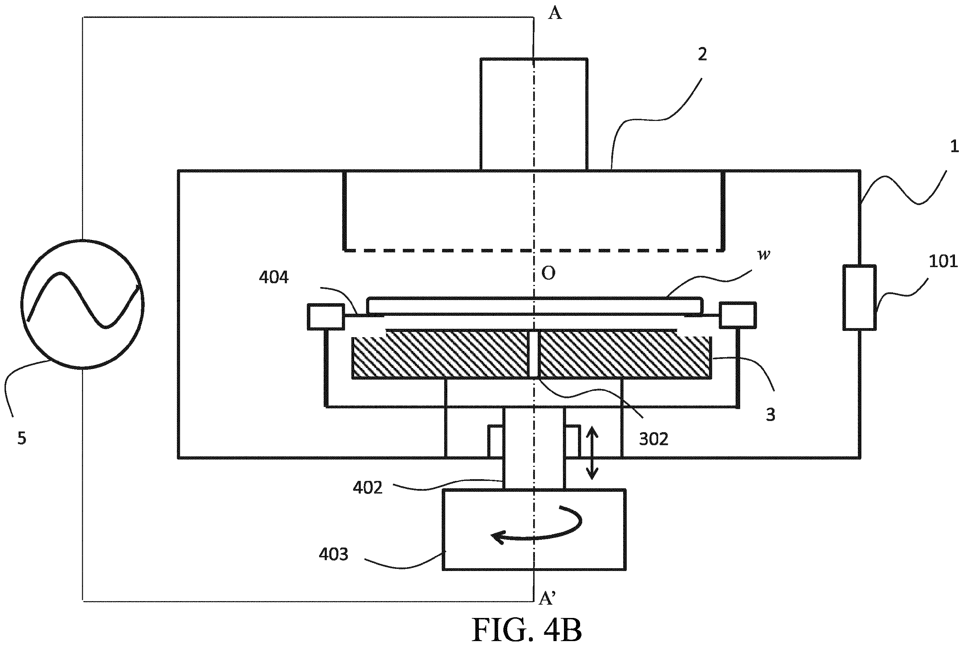

As shown in FIG. 4A and FIG. 4B, when the substrate w needs to be rotated, the lifting member 402 drives the supporting ring 404 to lift up in the vertical direction to lift the substrate w to separate the substrate w from the heating tray 3. Then the rotating mechanism 403 rotates the supporting ring 404 to rotate the substrate w at a set angle. The substrate w stops rotating after rotating at a set angle, and the lifting member 402 drives the supporting ring 404 to move down vertically to place the substrate w on the heating tray 3 for thin film deposition.

In this embodiment, the supporting ring 404 arranged at the bottom of the outer periphery of the substrate w for holding the substrate w up to adjust the rotation setting angle of the substrate w to realize the rotation of the substrate w around the rotation shaft AA'. It compensates for the deposition on the substrate w and realize the uniformity and stability of the film deposition of the PECVD layer stack structure.

Other settings in this embodiment are the same as those in the embodiment 1, and will not be repeated here.

### Embodiment six

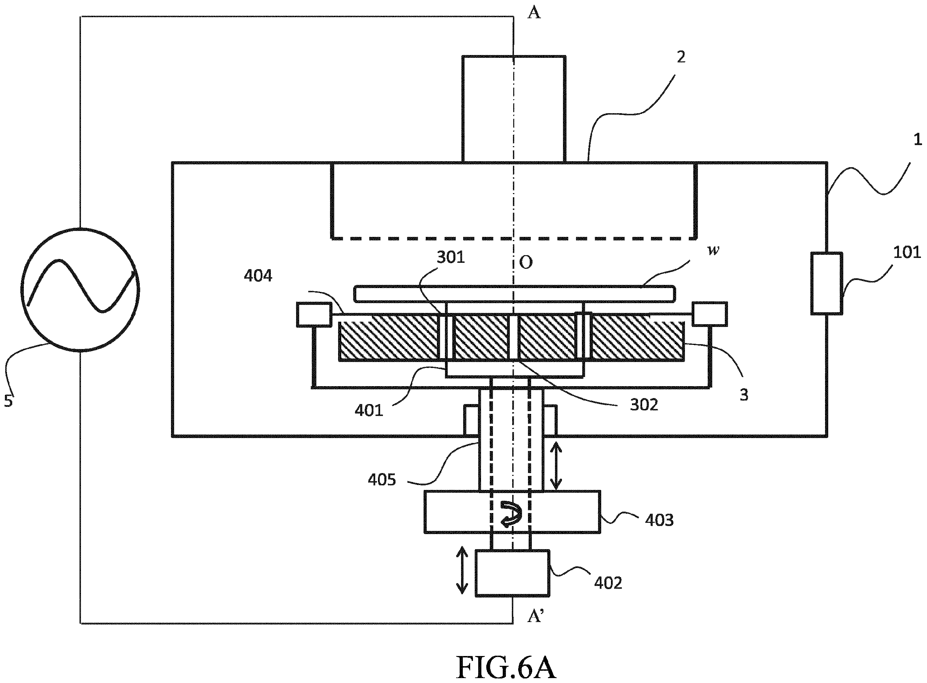

As shown in FIG. 6A to FIG. 7, embodiment 6 provides a thin film deposition device, compared with the embodiment 1, the difference is:

The thin film deposition device further includes: a supporting member configured for supporting the substrate w including an ejector pin 401 and a supporting ring 404; a first lifting member 402 connected to the ejector pin 401 for driving the ejector pin 401 rise or fall in the vertical direction for the manipulators to remove the substrate w from the heating tray 3 or place the substrate w on the heating tray 3; a second lifting member 405 connected to the supporting ring 404 for driving the supporting ring 404 to rise or fall vertically to lift the substrate w away from the heating tray 3 or place the substrate w on the heating tray 3 .

In the embodiment 6, the rotating mechanism 403 is arranged at the bottom of the second lifting member 405. It is configured to drive the supporting ring 404 and the second lifting member 405 to rotate synchronously with the center line AA' of the substrate w as the rotation shaft to drive the substrate w to rotate.

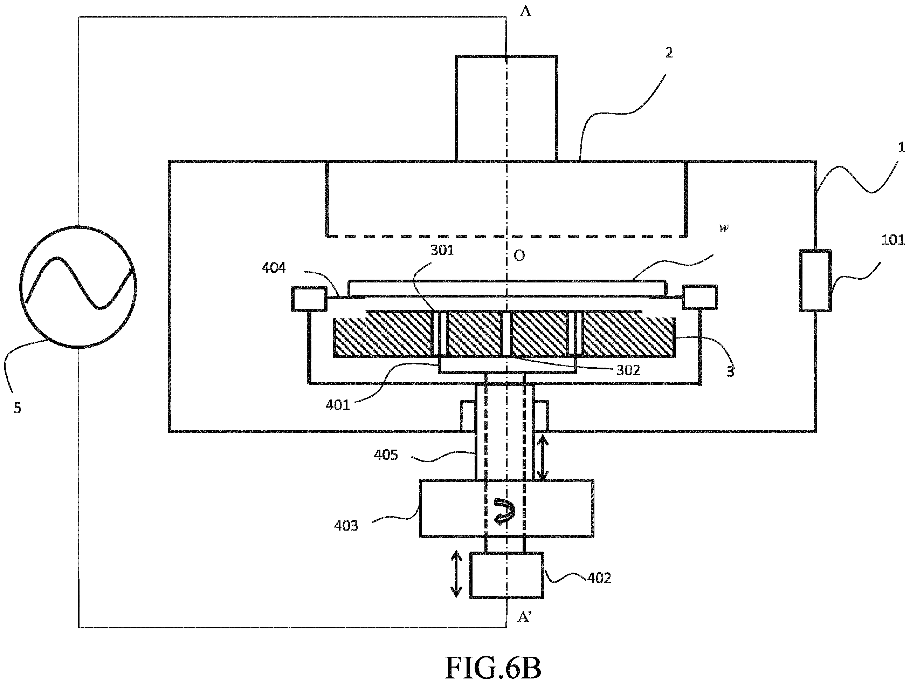

As shown in FIG. 6A and FIG. 6B, the heating tray 3 is provided with a first through hole 301, and the ejector pin 401 is arranged in the first through hole 301 for supporting the substrate w through the first through hole 301.

When the manipulator puts the substrate w into the processing chamber 1, the first lifting member 402 drives the ejector pin 401 to rise vertically and protrudes from the first through hole 301 to bearing the substrate w put in by the manipulator. Then the second lifting member 402 drives the ejector pin 401 to fall vertically, and the ejector pin 401 retracts into the first through hole 301, so that the substrate w is placed on the heating tray 3 for subsequent film deposition. When the manipulators remove the substrate w out of the processing chamber 1, the first lifting member 402 drives the ejector pin 401 to rise vertically and protrudes from the first through hole 301 to lift the substrate w from the heating tray 3 to take away the substrate w easily. Then the first lifting member 402 drives the ejector pin 401 to fall in the vertical direction, and the ejector pin 401 retracts into the first through hole 301 .

When the substrate w needs to be rotated, the second lifting member 405 drives the supporting ring 404 to lift up in the vertical direction to lift the substrate w untill the substrate w separate from the heating tray 3. Then the rotating mechanism 403 drives the supporting ring 404 to rotate to rotate the substrate w by a set angle. Stopping the substrate w rotation after the substrate is rotate to a set angle, and the second lifting member 405 drives the supporting ring 404 to move down vertically to place the substrate w on the heating tray 3 for thin film deposition.

Other settings in this embodiment are the same as those in the embodiment 1, and will not be repeated here.

### Embodiment seven

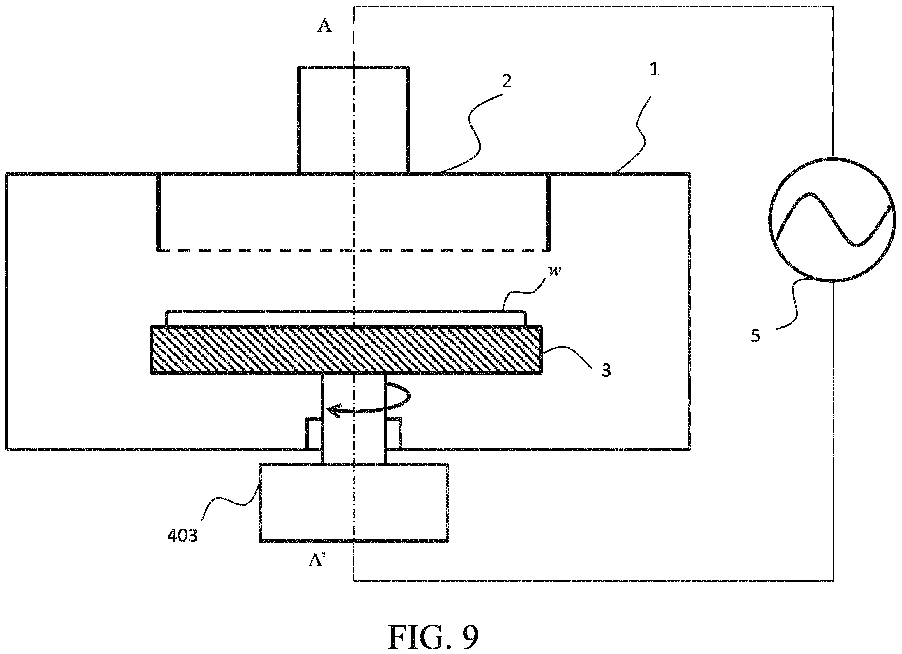

As shown in FIG. 9, embodiment 7 provides a thin film deposition device. The thin film deposition device includes: a processing chamber 1 configured to perform thin film deposition; a gas supply assembly 2 arranged on the top wall of the processing chamber 1and configured to supply process gas to the processing chamber 1; a heating tray 3 arranged below the gas supply assembly 2 and configured to bear and heat the substrate w; the radio frequency source 5 configured to provide radio frequency power to form a radio frequency electric field in the processing chamber 1 to activate the process gas in the processing chamber 1 to dissociate into plasma, and the plasma performs thin film deposition on the substrate w; the rotating mechanism 403 connected to the heating tray 3 and configured to drive the heating tray 3 to rotate around the shaft AA' passing through the center of the substrate w to rotate the substrate w synchronously.

When the rotating mechanism 403 drives the heating tray 3 and the substrate w to rotate, stopping to introduce the process gas into the processing chamber 1 and introducing inert gas or nitrogen gas into the processing chamber 1 to maintain the pressure in the processing chamber 1. At the same time, keeping the radio frequency source 5 in an on state.

In this embodiment, the heating tray 3 drives the substrate w to rotate synchronously with the shaft AA' passing through the center of the substrate w as the rotation shaft including: after the heated tray 3 is rotated around the rotation shaft AA' in the forward direction by a set angle, it will be rotated around the rotation shaft AA' in the reverse direction.

### Embodiment Eight

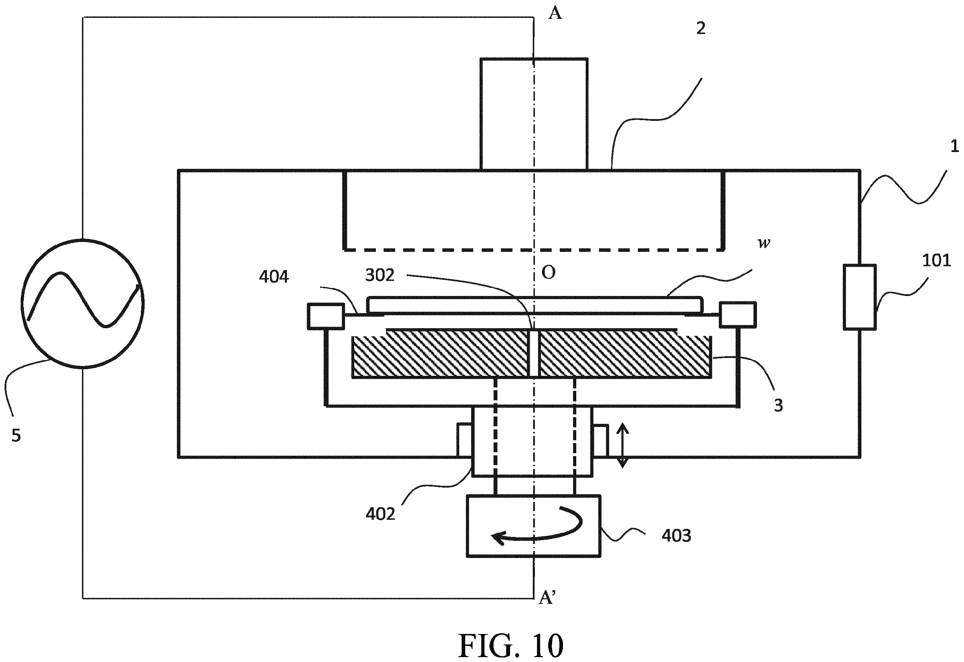

As shown in FIG. 10, the embodiment provides a thin film deposition device. The thin film deposition device includes: a processing chamber 1 configured to perform thin film deposition; a gas supply assembly 2 arranged on the top wall of the processing chamber 1 and configured to supply process gas to the processing chamber 1; a heating tray 3 arranged below the gas supply assembly 2 and configured to bear and heat the substrate w; the radio frequency source 5 configured to provide radio frequency power to form a radio frequency electric field in the processing chamber 1 to activate the process gas in the processing chamber 1 to dissociate into plasma, and the plasma performs thin film deposition on the substrate w.

The thin film deposition device also includes: a supporting member configured to support the substrate w, wherein the supporting member is a supporting ring 404 arranged at the bottom of the edge of the substrate w; a lifting member 402 connected to the supporting ring 404 and configured to drive the supporting ring 404 to rise or fall in a vertical direction to lift the substrate w away from the heating tray 3 or place the substrate w on the heating tray 3 .

In the embodiment 8, the rotating mechanism 403 is connected to the heating tray 3 for driving the heating tray 3 to rotate around the shaft AA' passing through the center of the substrate w.

When the rotating mechanism 403 drives the heating tray 3 to rotate, stopping to introduce the process gas into the processing chamber 1 and introducing inert gas or nitrogen gas into the processing chamber 1 to maintain the pressure in the processing chamber 1 to keep the radio frequency source 5 in an on state.

In the embodiment 8, the rotation of the heating tray 3 with the shaft AA' passing through the center of the substrate w as the rotation shaft includes: after the heating tray 3 is rotated around the rotation shaft AA' in the positive direction at a set angle, it will be rotated around the rotation shaft AA' in the reverse direction.

As shown in FIG. 10, when the heating tray 3 needs to be rotated, the lifting member 402 drives the supporting ring 404 to lift up in the vertical direction to lift the substrate w until the substrate separate from the heating tray 3. Then the rotating mechanism 403 drives the heating tray 3 to rotate by a set angle. Stopping the heating tray3 rotating after the heating tray 3 rotates at the set angle, and the lifting member 402 drives the supporting ring 404 to fall in the vertical direction to place the substrate w on the heating tray 3 for thin film deposition.

### Embodiment nine

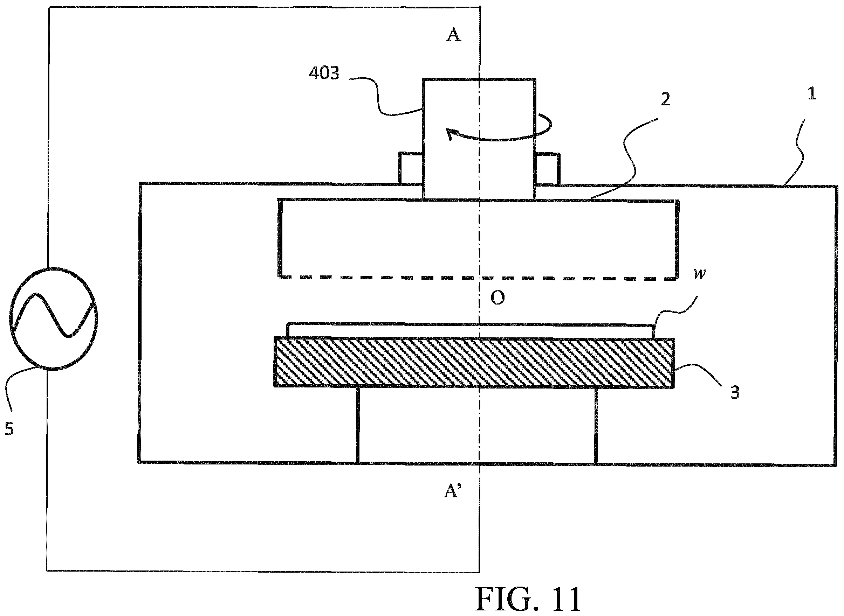

As shown in FIG. 11, the embodiment provides a thin film deposition device, the thin film deposition device includes: a processing chamber 1 configured to perform thin film deposition; a gas supply assembly 2 arranged on the top wall of the processing chamber 1and configured to supply the process gas to the processing chamber 1; the heating tray 3 arranged below the gas supply assembly 2 and configured to bear and heat the substrate w; the radio frequency source 5 configured to provide radio frequency power to activate the process gas in the processing chamber 1 to dissociate into plasma, and the plasma performs thin film deposition on the substrate w; the rotating mechanism 403 connected to the gas supply assembly 2 and configured to drive the gas supply assembly 2 to rotate.

In the embodiment 9, the rotating mechanism 403 is a motor 403, and the motor 403 is connected to the gas supply assembly 2 to drive the gas supply assembly 2 to rotate. In the embodiment 9, after multiple substrates w are sequentially put into the processing chamber 1 to complete the film deposition process, the rotating mechanism 403 drives the gas supply assembly 2 to rotate at a set angle.

Preferably, when the rotating mechanism 403 drives the gas supply assembly 2 to rotate, stopping to introduce the process gas into the processing chamber 1 and introducing inert gas or nitrogen gas into the processing chamber 1 to maintain the pressure in the processing chamber 1. At the same time, keeping the radio frequency source 5 in an on state. Because some impurity particles are suspended in the processing chamber 1 after depositing a certain number of layers of film on the substrate w, at this time, keeping the radio frequency source 5 in an on state and the processing chamber 1 will be filled with a radio frequency electric field. The impurity particles are charged under the action of the internal radio frequency electric field in the processing chamber 1, and the charged impurity particles remain suspended and will not fall on the surface of the substrate w, which effectively prevents the impurity particles from falling on the thin film deposited on the substrate w to avoid contamination of the thin film deposited on the substrate w .

The uniformity of the process gas supplied by the gas supply assembly 2 is improved through rotating the gas supply assembly 2, and the uniformity of the thickness of the deposited film on the substrate w is improved too. It realizes the uniformity and stability of the film deposition of the PECVD layer stack structure.

### Embodiment ten

As shown in FIG. 9, the embodiment provides a thin film deposition device, compared with the embodiment 7, the difference is:

The rotating mechanism 403 is connected to the heating tray 3 to drive the heating tray 3 to rotate around the center shaft of the substrate as the shaft of rotation, so as to drive the substrate w to rotate synchronously. When the rotating mechanism 403 drives the heating tray 3 to rotate the substrate w to rotate, the radio frequency source 5 is adjusted to be turned off.

Other settings in this embodiment are the same as those in the embodiment 7, and will not be repeated here.

### Embodiment eleven

As shown in FIG. 10, the embodiment provides a thin film deposition device, compared with the embodiment 8, the difference is:

When the rotating mechanism 403 drives the heating tray 3 to rotate, the radio frequency source 5 is adjusted to be turned off.

Other settings in this embodiment are the same as those in the embodiment 8, and will not be repeated here.

### Embodiment twelve

Due to the deformation caused by the long-term use of the gas supply assembly 2 in PECVD, the distribution of the process gas delivered into the processing chamber 1 is unevenly. The unevenly distribution results in different gas flow obtained at different positions on the substrate, which leads to deviation in the thickness of the film deposited by the plasma on the substrate and leads to the deviation of the etched through hole from the vertical direction during the etching process. Finally, the above problems lead to the failure of the semiconductor device.

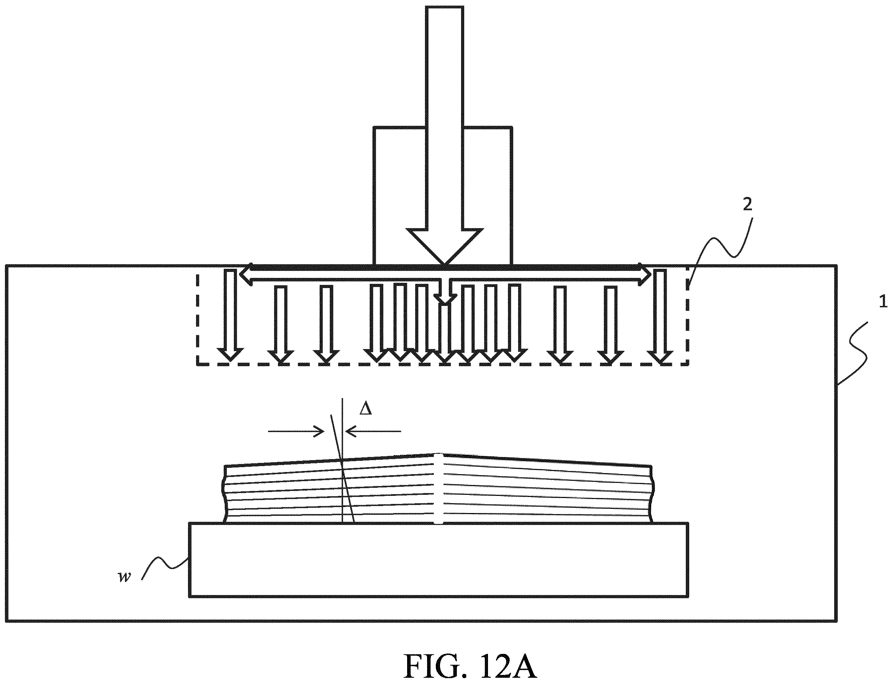

As shown in FIG. 12A, when the process gas is introduced into the gas supply assembly 2, the gas flow at the central position of the gas supply assembly 2 is greater than the gas flow at the outer periphery of the gas supply assembly 2. So that in the film deposition process, the thickness of the thin film deposited on the substrate w at the central position is smaller than the thickness of the thin film at the outer periphery, and the film stacked on the surface of the substrate w is tilted at a certain angle Δ that resulting in uneven thickness of the deposited film on the substrate w and further leading to the defect that the etched through hole deviates from the vertical direction during the subsequent etching process.

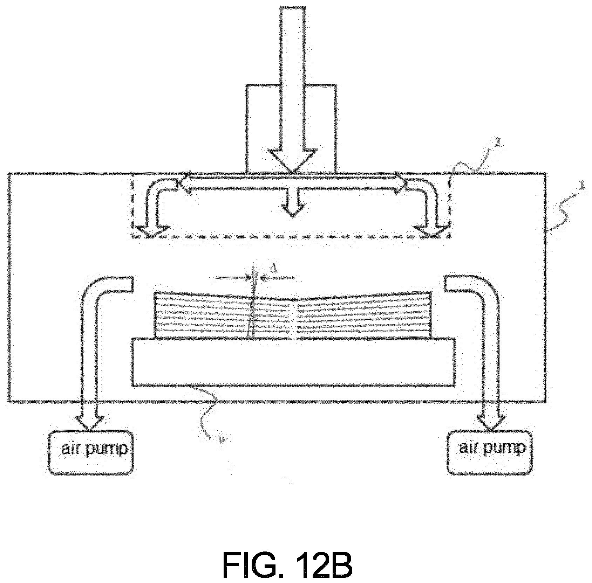

As shown in FIG. 12B, the processing chamber 1 is connected to an air pump for extracting exhaust gas during the deposition process of the processing chamber 1. However, the extraction of the exhaust gas by the air pump may easily leads to the gas flow at the outer periphery of the gas supply assembly 2 being greater than the gas flow at the central position of the gas supply assembly 2 that resulting in the thickness of the thin film deposited on the substrate w at the central position is smaller than the thickness of the thin film at the outer periphery. It also results in incline at a certain angle Δ of the film stacked on the surface of the substrate w and uneven thickness of the deposited film on the substrate w, which leads to the defect that the etched through hole deviates from the vertical direction during the subsequent etching process.

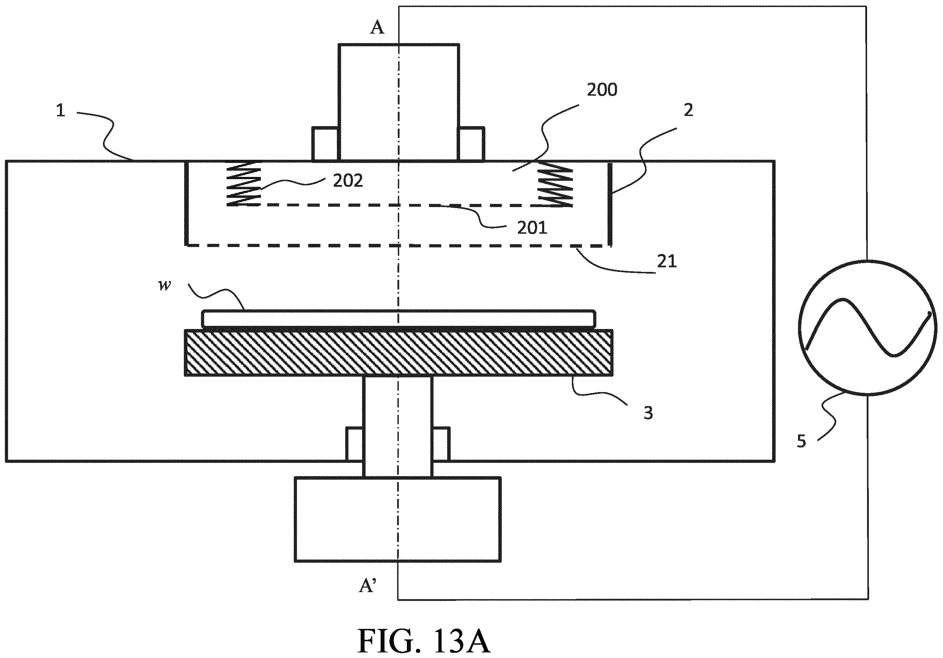

In order to solve the above-mentioned defects of uneven deposition at the outer periphery and the central position of the deposited film, referring to FIG. 13A to FIG. 13C, this embodiment provides a thin film deposition device. Specifically, as shown in FIG. 13A, the thin film deposition device includes: a processing chamber 1 configured to perform thin film deposition; a gas supply assembly 2 arranged on the top wall of the processing chamber 1for supplying process gas to the processing chamber 1having a first porous plate 21; a heating tray 3 deposited under the gas supply assembly 2 for bearing and heating the substrate w; a gas regulating unit 200 arranged in the gas supply assembly 2, and a second porous plate 201 is arranged at the bottom end of the gas regulating unit 200, and the second porous plate 201 is arranged opposite to the first porous plate 21 of the gas supply assembly 2. In order to adjust the flow direction of the process gas in the gas supply assembly 2, the gap between the second porous plate 201 and the first porous plate 21 need to be adjusted. So that the process gas in the gas supply assembly 2 can be fully mixed to improve the non-uniform of the internal plasma distribution of the processing chamber 1that realizing the uniformity and stability of the film deposition of the PECVD layer stack structure to avoid the deviation of the through hole from the vertical direction during the subsequent etching process of the film deposited on the substrate w, thereby further ensuring the stability of semiconductor device performance. In addition, the thin film deposition device also includes a controller, which is respectively connected to the gas supply assembly 2, the heating tray 3, and the gas regulating unit 200. The controller is configured to control the gas supply assembly 2, the heating tray 3, and the gas regulating unit 200 to work.

As shown in FIG. 13A, the thin film deposition device also includes a radio frequency source 5, which is configured to provide radio frequency power to form a radio frequency electric field in the processing chamber 1 to activate the process gas in the processing chamber 1 to dissociate into plasma for performing thin film deposition on the substrate w. Wherein, the high-frequency frequency of the radio frequency source 5 is an integer multiple n of 13.56 MHz, where n=1, 2, 3, •••, 8. The low-frequency frequency range of the radio frequency source 5 is 20KHz-400KHz.

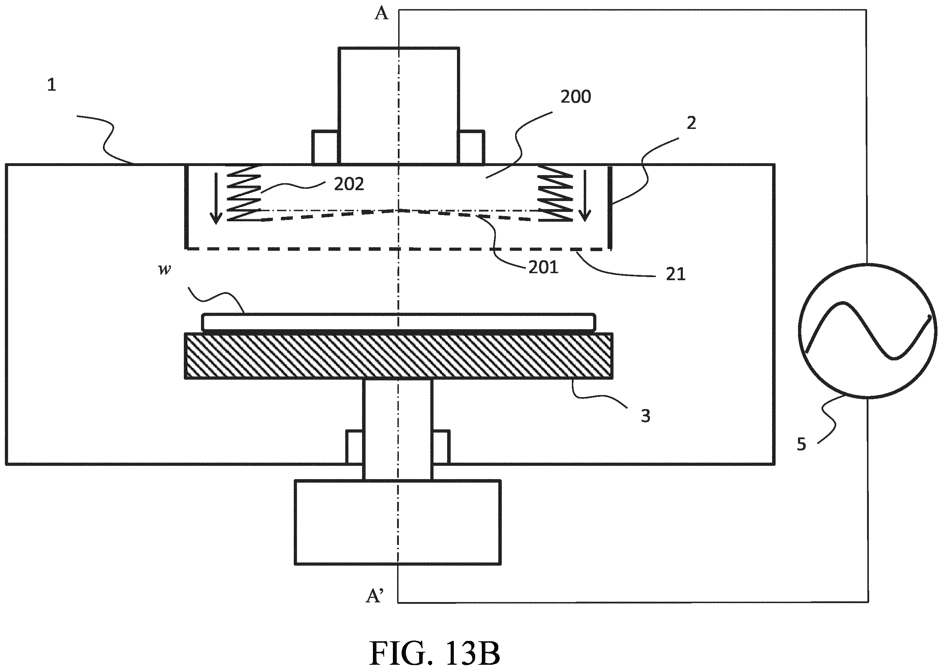

As shown in FIG. 13B to FIG. 13C, the side wall 202 of the gas regulating unit 200 can be stretched or shrunk in the vertical direction to adjust the gap between the second porous plate 201 and the first porous plate 21to mix the process gas in the gas supply assembly 2. It improves the defect that the uneven deposition of the film on the surface of the substrate w caused by the uneven distribution of the plasma during the film deposition process.

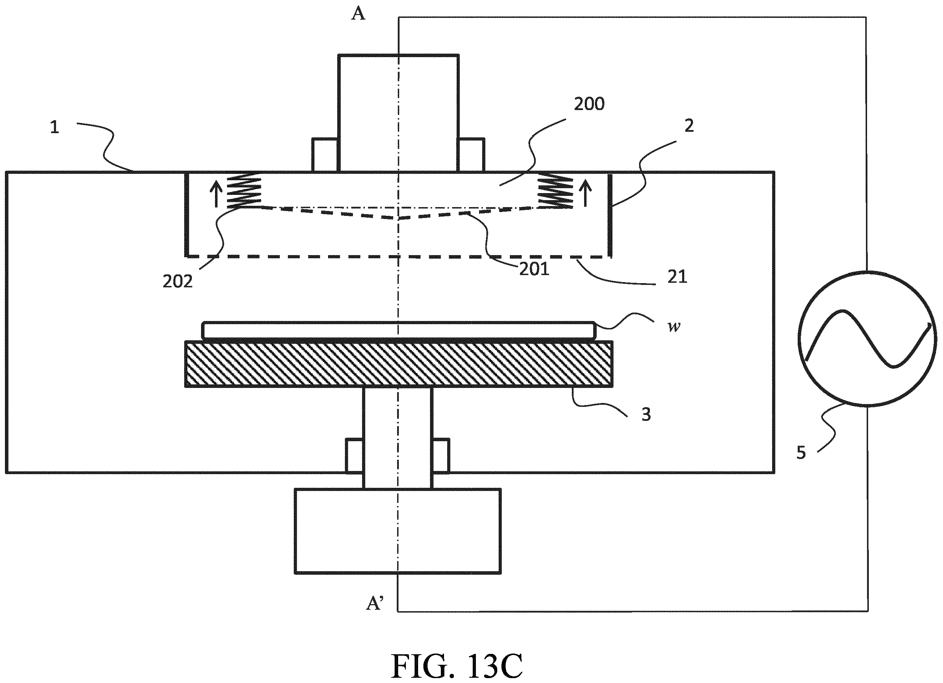

In embodiment 12, as shown in FIG. 13B and FIG. 13C, the side wall 202 of the gas regulating unit 200 is a bellow, which can be stretched vertically downwards or shrunk upwards. The second porous plate 201 at the bottom of the gas regulating unit 200 is bent or arc-shaped to adjust the gap between the second porous plate 201 and the first porous plate 21, so that the process gas in the gas supply assembly 2 can be fully mixed. It also improves the defect that the uneven deposition of the film on the surface of the substrate w caused by the uneven distribution of the plasma.

### Embodiment thirteen

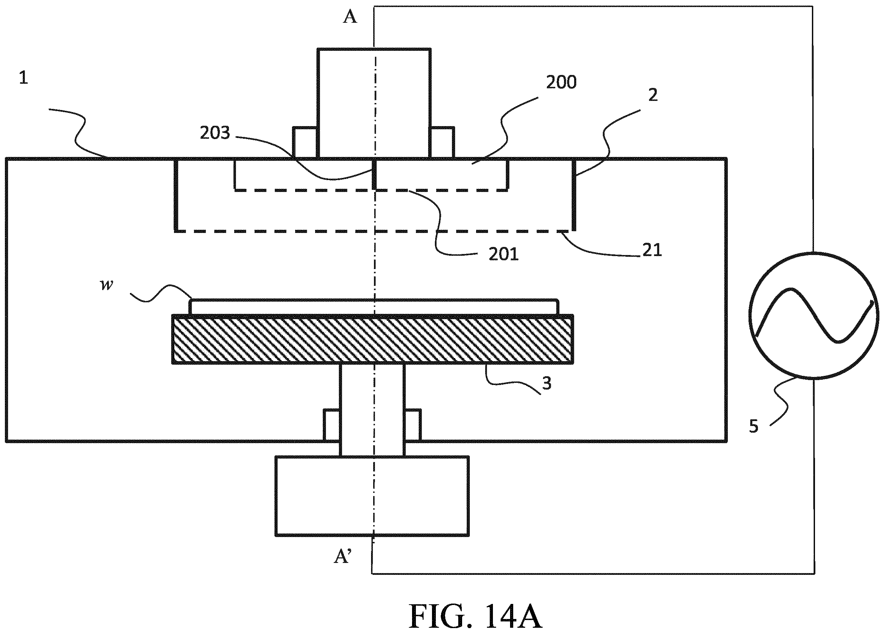

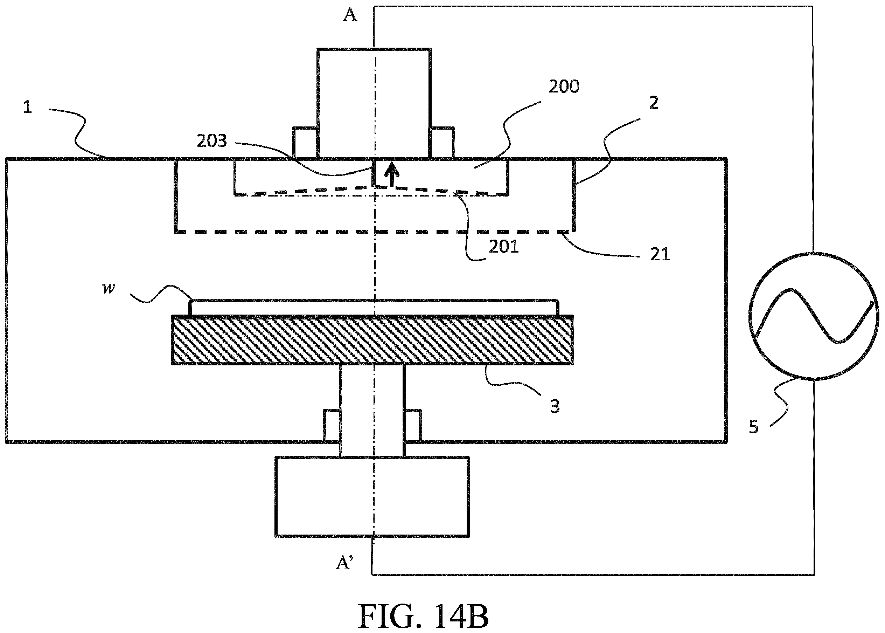

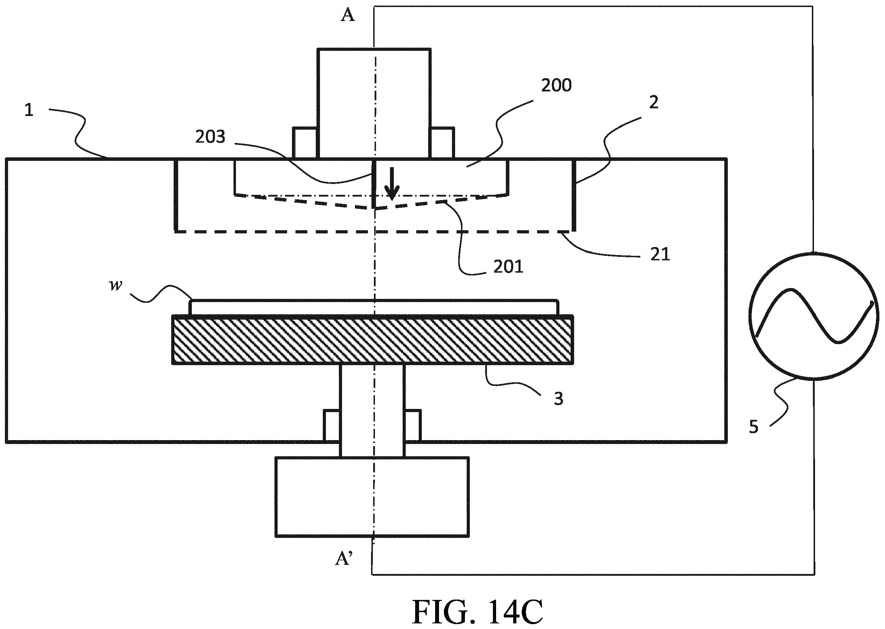

As shown in FIG. 14A to FIG. 14C, the embodiment provides a thin film deposition device, compared with the embodiment 12, the difference is:

The gas regulating unit 200 includes a telescopic rod 203, and the telescopic rod 203 is connected to the second porous plate 201. The telescopic rod 203 can be stretched or shrunk in the vertical direction, so that the second porous plate 201 is bent or arc-shaped to adjust the gap between the second porous plate 201 and the first porous plate 21. The process gas in the gas supply assembly 2 can be fully mixed to improving the defects of non-uniform film deposition on the surface caused by uneven distribution of the plasma in the processing chamber 1.

In the embodiment 13, as shown in FIG. 14A, the telescopic rod 203 is arranged at the center of the gas regulating unit 200 and connected to the center of the second perforated plate 201.

Other settings in the embodiment 13 are the same as those in the embodiment 12, and will not be repeated here.

### Embodiment fourteen

In order to solve the problem of uneven film deposition on the surface of substrate w in the prior art, referring to FIG. 2A to FIG. 10 and FIG. 15A, this embodiment provides a thin film deposition method, which is realized based on the thin film deposition devices in the above-mentioned embodiments 1-8 and embodiments 10-11.

Specifically, the film deposition method includes the following steps:
Step S1, placing the substrate w in the processing chamber 1 of PECVD and evacuating the processing chamber 1, so that the substrate w to be deposited with a thin film is in a vacuum environment;
Step S2, introducing process gas into the processing chamber 1 and turning on the radio frequency source 5, dissociating the process gas in the processing chamber 1 into plasma and depositing a certain number of layers of thin films on the substrate w;
Step S3, stopping to introduce the process gas into the processing chamber 1 and introducing a non-process gas, such as an inert gas or nitrogen gas, into the processing chamber 1 to maintain the pressure in the processing chamber 1;
Step S4, keeping the radio frequency source 5 in an on state, rotating the substrate w or rotating the heating tray 3 or synchronously rotating the substrate w and the heating tray 3 by a set angle;
Step S5, introducing process gas into the processing chamber 1 again, and then depositing a certain number of layers of thin films on the substrate w;
Step S6, stopping to introduce the process gas into the processing chamber 1 and introducing a non-process gas, such as an inert gas or nitrogen gas, into the processing chamber 1 to maintain the pressure in the processing chamber 1;
Step S7, determining whether the number of layers of the deposited film on the substrate w satisfies the set number of layers; if not, going back to the step S2; if yes, executing step S8;
Step S8, taking the substrate w out from the processing chamber 1 to complete the film deposition process of the substrate w.

Wherein, the rotation shaft AA' of the rotation of the substrate w or the rotation of the heating tray 3 or the synchronous rotation of the substrate w and the heating tray 3 is perpendicular to and passing through the center O of the substrate w.

The thin film deposited on the substrate w includes the first material and the second material deposited alternately. In the embodiment, the first material is silicon oxide, and the second material is silicon nitride.

Wherein, the thin film deposition method further includes: after each material is deposited on the surface of the substrate w, the waste gas in the processing chamber 1 needs to be pumped away, and then subsequent process steps are performed.

When the substrate w is rotated or the heating tray 3 is rotated or the substrate w and the heating tray 3 are rotated synchronously, process gas is stopped to introduce, and inert gas or nitrogen gas will be introduced to maintain the pressure in the processing chamber 1. At the same time, keep the radio frequency source 5 in an on state. After depositing a certain number of layers of film on the substrate w, some impurity particles are suspended in the processing chamber 1. At this time, keep the radio frequency source 5 in an on state, and the processing chamber 1 is filled with a radio frequency electric field that the impurity particles are charged under the action of the internal radio frequency electric field in the processing chamber 1. The charged impurity particles remain suspended and will not fall on the surface of the substrate w, which effectively prevents the impurity particles from falling on the thin film deposited on the substrate w to avoid pollution to the thin film deposited on the substrate w.

After the thin film deposition is completed, (the number of rotations of the substrate w+1) * the set angle of each time of rotation of the substrate w=360°. In the embodiment 14, as shown in FIG. 8A to FIG. 8D, after the film deposition is completed, the number of rotation times of the substrate w is 5, and the set angle of each rotation is 60 degrees. It is also possible that the number of rotation times of the substrate w is 3, and the set angle of each rotation is 90 degrees. It is also possible that the number of rotation times of the substrate w is 2, and the set angle of each rotation is 120 degrees. It is also possible that the number of rotation times of the substrate w is 1, and the set angle of each rotation is 180 degrees.

However, when the substrate w rotates or the heating tray 3 rotates, the radio frequency source 5 is kept in an on state. After the substrate w is separated from the heating tray 3, the gap between the back of the substrate w and the heating tray 3 is too large, which may easily lead to the occurrence of arc discharge. In the embodiment 14, in order to avoid the phenomenon of arc discharge when the substrate w is separated from the heating tray 3 when the radio frequency source 5 is in an on state, it is necessary to adjust the gap between the substrate w and the heating tray 3 to be smaller than the set value to avoid the substrate w from detaching from the heating tray 3 which leads to the generation of arc discharge phenomena in the plasma atmosphere. In the embodiment 14, the set value of the gap between the substrate w and the heating tray 3 is m, where 0<m ≦5 mm. Therefore, under the condition that the gap between the substrate w and the heating tray 3 is smaller than the set value, the radio frequency source 5 is kept in an on state to reduce the risk of arc discharge on the substrate w and ensure the safety and stability of the thin film deposition process.

In the embodiment 14, when the number of layers of film deposited on the surface of the substrate w is small (for example, less than 150 layers), the method of driving the heating tray 3 to drive the substrate w to rotate synchronously can be configured to avoid arc discharge when the substrate w is lifted up. In the case that the surface of the heating tray 3 is uneven, the method of lifting the substrate w and driving the substrate w to rotate or driving the heating tray 3 to solve the problem of uneven temperature of the heating tray 3 to the uniformity of the deposited film on the surface of the substrate w.

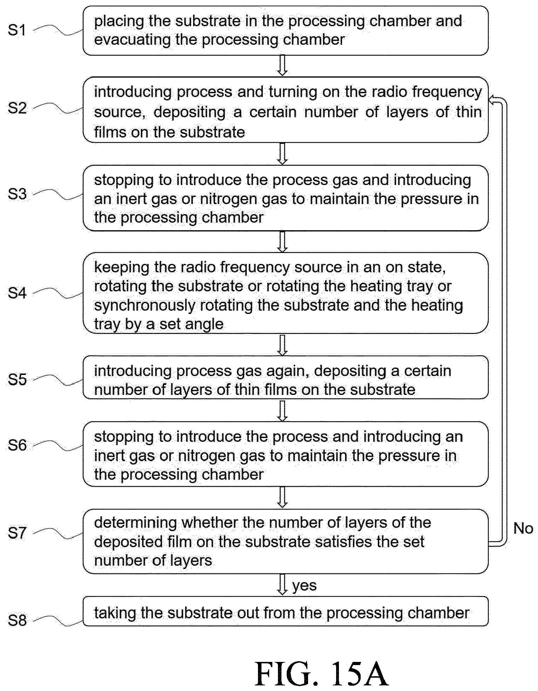

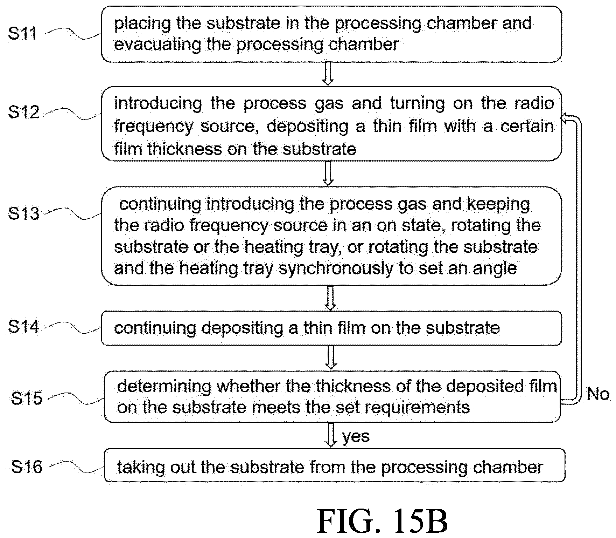

Alternatively, when depositing thin films of a single material, such as FIG. 15B as shown, the film deposition method includes the following steps:
Step S11, placing the substrate in the processing chamber and evacuating the processing chamber;
Step S12, introducing the process gas and turning on the radio frequency source, and depositing a thin film with a certain film thickness on the substrate;
Step S13, continuing introducing the process gas and keeping the radio frequency source in an on state, rotating the substrate or the heating tray, or rotating the substrate and the heating tray synchronously to set an angle;
Step S14, continuing depositing a thin film on the substrate;
Step S15, determining whether the thickness of the deposited film on the substrate meets the set requirements, if not, going back to the step S12; if yes, executing step S16;
Step S16, taking out the substrate from the processing chamber.

During the film growth process, the substrate w is rotated to ensure that the film deposited on the surface of the substrate w is more uniform.

### Embodiment fifteen

This embodiment 15 provides a film deposition method, compared with the embodiment 14, the difference is:

When the radio frequency source 5 is in an on state, non-process gas is introduced into the gap between the substrate w and the heating tray 3 through the second through hole 302 on the heating tray 3 to reduce the risk of arc discharge when the substrate w is separated from the heating tray 3. Wherein, the non-process gas is an inert gas or nitrogen.

When the gap between the substrate w and the heating tray 3 is filled with non-process gas, the radio frequency source 5 is kept in an on state to reduce the risk of arc discharge on the substrate w and ensure the safety and stability of the thin film deposition process.

Other settings in the embodiment 15 are the same as those in the embodiment 14, and will not be repeated here.

### Embodiment sixteen

The embodiment 16 provides a thin film deposition method, compared with the embodiment 14, the difference is:
Keeping the radio frequency source 5 in the in an on state and turning down the radio frequency power of the radio frequency source 5 to be lower than the radio frequency power of the radio frequency source 5 during the film deposition process to reduce the risk of arc discharge when the substrate w is separated from the heating tray 3, thereby ensuring the safety and stability of the thin film deposition process.

Other settings in this embodiment are the same as those in the embodiment 14, and will not be repeated here.

### Embodiment seventeen

The embodiment 17 provides a thin film deposition method, compared with the embodiment 14, the difference is:
Before the rotation of the substrate w or the rotation of the heating tray 3 or the synchronous rotation of the substrate w and the heating tray 3, the radio frequency source 5 is turned off and the processing chamber 1 is purified.

After depositing a certain number of layers of film on the substrate w, there will be impurity particles in the processing chamber 1, and the dirtier the processing chamber 1, the more likely arc discharge will occur when the substrate w is separated from the heating tray 3 in the processing chamber 1. Preferably, before rotating the substrate w or rotating the heating tray 3 or synchronous rotating the substrate w and the heating tray 3, the radio frequency source 5 can be turned off, and the nitrogen gas can be supplied to the processing chamber 1 through the gas supply assembly 2. Then the processing chamber 1 is subjected to purification treatment. After the purification treatment is completed, the radio frequency source 5 is re-adjusted to be in an on state.

Other settings in the embodiment 17 are the same as those in the embodiment 14, and will not be repeated here.

### Embodiment eighteen

As shown in FIG. 8A to FIG. 9 and FIG. 16, this embodiment 18 provides a thin film deposition method, which is realized based on the thin film deposition apparatus in the above-mentioned embodiment 7 and embodiment 10.

Specifically, the film deposition method includes the following steps:
Step S21, placing the substrate w in the processing chamber 1 and evacuating the processing chamber 1, so that the substrate w to be deposited with a thin film is in a vacuum environment;
Step S22, introducing process gas into the processing chamber 1 and turning on the radio frequency source 5 to dissociate the process gas into plasma for depositing a certain number of layers of thin films on the substrate w;
Step S23, stopping to introduce the process gas into the processing chamber 1, and introducing an inert gas or nitrogen gas into the processing chamber 1 to maintain the pressure in the processing chamber 1;
Step S24, adjusting the radio frequency source 5 to be off, and the heating tray 3 drives the substrate w to rotate synchronously by a set angle;
Step S25, introducing the process gas into the processing chamber 1 again and adjusting the radio frequency source 5 to be on, then depositing a certain number of layers of film on the substrate w;
Step S26, stopping to introduce the process gas into the processing chamber 1, and introducing an inert gas or nitrogen gas into the processing chamber 1 to maintain the pressure in the processing chamber 1;
Step S27, determining whether the number of layers of the deposited thin film on the substrate w satisfies the set number of layers; if not, going back to the step S22; if yes, executing step S28;
Step S28, the substrate w is taken out from the processing chamber 1 to complete the film deposition process.

Wherein, the rotation shaft AA' that the heating tray 3 rotates synchronously with the substrate w is perpendicular to and passing through the center O of the substrate w. In the embodiment 18, the heating tray 3 and the substrate w rotated synchronously around the shaft AA' passing through the center of the substrate w as the rotation shaft further includes: after the heating tray 3 rotates around the rotation shaft AA' in the positive direction at a set angle, then rotates in the reverse direction around the rotation shaft AA'.

The thin film deposited on the substrate w includes the first material and the second material deposited alternately.

Wherein, the thin film deposition method further includes: after each material is deposited on the surface of the substrate w, the waste gas in the processing chamber 1 needs to be pumped away, and then subsequent process steps are performed.

After the thin film deposition is completed, (the number of rotations of the substrate w+1) *the set angle of each time of rotation of the substrate w=360°. In this embodiment 18, as shown in FIG. 8A to FIG. 8D, after the film deposition is completed, the number of rotation times of the substrate w is 5, and the set angle of each rotation is 60 degrees. It is also possible that the number of rotation times of the substrate w is 3, and the set angle of each rotation is 90 degrees. It is also possible that the number of rotation times of the substrate w is 2, and the set angle of each rotation is 120 degrees. It is also possible that the number of rotations of the substrate w is 1, and the set angle of each rotation is 180 degrees.

### Embodiment nineteen

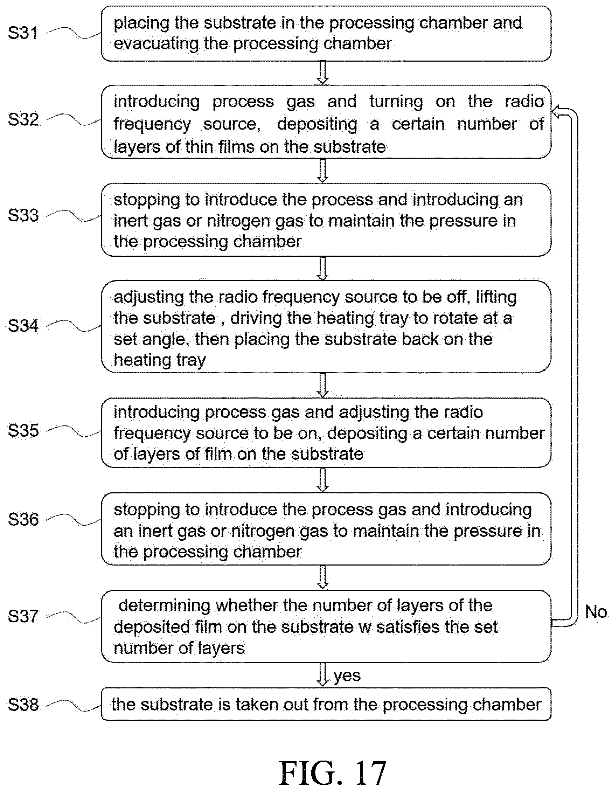

As shown in FIG. 10 and FIG. 17, the embodiment 19 provides a thin film deposition method, which is realized based on the thin film deposition device in the above-mentioned embodiment 8 and embodiment 11.

Specifically, the film deposition method includes the following steps:
Step S31, placing the substrate w in the processing chamber 1 and evacuating the processing chamber 1, so that the substrate w to be deposited with a thin film is in a vacuum environment;
Step S32, introducing process gas into the processing chamber 1, and turning on the radio frequency source 5 to dissociate the process gas in the processing chamber 1 into plasma, and depositing a certain number of layers of thin films on the substrate w;
Step S33, stopping to introduce the process gas into the processing chamber 1, and introducing an inert gas or nitrogen gas into the processing chamber 1 to maintain the pressure in the processing chamber 1;
Step S34, adjusting the RF source 5 to be off, lifting the substrate w, and driving the heating tray 3 to rotate at a set angle, then placing the substrate w back on the heating tray 3;
Step S35, introducing process gas into the processing chamber 1, and adjusting the radio frequency source 5 to be on, then depositing a certain number of layers of film on the substrate w;
Step S36, stopping to introduce the process gas into the processing chamber 1, and introducing an inert gas or nitrogen gas into the processing chamber 1 to maintain the pressure in the processing chamber 1;
Step S37, determining whether the number of layers of the deposited film on the substrate w satisfies the set number of layers; if not, going back to the step S32; if yes, executing step S38;
Step S8, the substrate w is taken out from the processing chamber 1 to complete the film deposition process.

Wherein, the rotation shaft AA' of the heating tray 3 is perpendicular to and passing through the center O of the substrate w. In the embodiment 19, the rotation of the heating tray 3 with the shaft AA' passing through the center of the substrate w as the rotation shaft further includes: after the heating tray 3 rotates around the rotation shaft AA' in the positive direction at a set angle, the heating tray 3 is rotated in the reverse direction around the rotation shaft AA'.

In the embodiment 19, the thin film deposited on the substrate w includes the first material and the second material deposited alternately.

Wherein, the film deposition method further includes: after each material is deposited on the surface of the substrate w, exhaust gas in the processing chamber 1 needs to be pumped away, then subsequent process steps are performed.

### Embodiment twenty

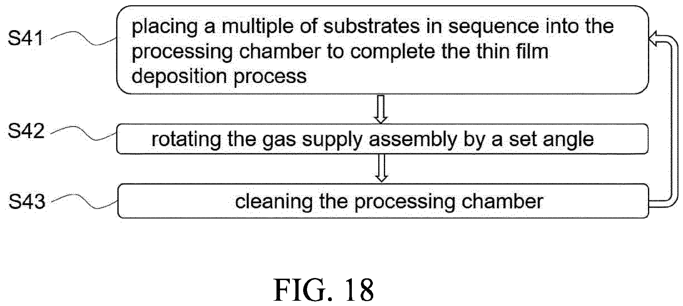

As shown in FIG. 11 and FIG. 18, the embodiment 20 provides a thin film deposition method, which is implemented based on the thin film deposition device in the above embodiment 9.

Specifically, the film deposition method includes the following steps:
Step S41, placing a multiple of substrates w in sequence into the processing chamber 1 to complete the thin film deposition process;
Step S42, rotating the gas supply assembly 2 by a set angle;
Step S43, cleaning the processing chamber 1 to ensure the cleanliness of the processing chamber 1, and repeating steps S41-S43 after the cleaning process is completed.

In the embodiment 20, the thin film deposited on the substrate w includes the first material and the second material deposited alternately. The multiple substrates w are placed in the processing chamber 1 sequentially to perform the thin film deposition process, including: after each material is deposited on the surface of each substrate w, the waste gas in the processing chamber 1 needs to be pumped away, and then perform the subsequent process.

### Embodiment twenty-one

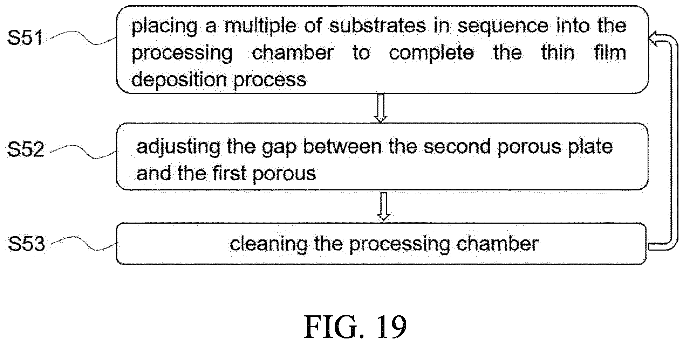

As shown in FIG. 13A to FIG. 13C and FIG. 19, this embodiment 21 provides a thin film deposition method, which is realized based on the thin film deposition device in the above embodiment 12.

As shown in FIG. 13A to FIG. 13C, the bottom end of the gas supply assembly 2 is provided with a first porous plate 21. the gas supply assembly 2 is provided with a gas regulating unit 200, and the bottom end of the gas regulating unit 200 is provided with a second porous plate 201. The second porous plate 201 is arranged opposite to the first perforated plate 21 of the gas supply assembly 2. The flow direction of the process gas in the gas supply assembly 2 can be adjusted by adjusting the gap between the second porous plate 201 and the first porous plate 21, so that the process gas in the gas supply assembly 2 is fully mixed. It also improves the defect that the uneven deposition of the film on the surface of the substrate w caused by the uneven distribution of the plasma..

Specifically, as shown in FIG. 13A to FIG. 13C, the gap between the second porous plate 201 and the first porous plate 21 is adjusted by adjusting the side wall 202 of the gas regulating unit 200 to stretch or compress in the vertical direction. For details, referring to the above-mentioned embodiment 12, the described manner of adjusting the side wall 202 of the gas regulating unit 200 will not be repeated here. The thin film deposition method provided in the embodiment 21 comprises the following steps:
Step S51, placing a multiple of substrates w in sequence into the processing chamber 1 to complete the thin film deposition process;
Step S52, adjusting the gap between the second porous plate 201 and the first porous plate 21to adjust the gas flow direction of the process gas in the gas supply assembly 2;
Step S53, cleaning the processing chamber 1 to ensure the cleanliness of the processing chamber 1, and repeating steps S51-S53 after the cleaning process is completed.

### Embodiment twenty-two

As shown in FIG. 14A to FIG. 14C and FIG. 19, the embodiment 22 provides a thin film deposition method, which is implemented based on the thin film deposition device in the embodiment 13 above. Compared with the embodiment 21, the difference is:
As shown in FIG. 14A to FIG. 14C, a telescopic rod 203 is arranged in the gas regulating unit 200. The gap between the second porous plate 201 and the first porous plate 21 is adjusted by adjusting the telescopic rod 203 stretched or shrunk in vertical direction. For details, refer to the expansion and contraction of the gas regulating unit 200 described in the above-mentioned embodiment 13. The regulating method of the rod 203 will not be described in detail here.

Other settings in the embodiment 22 are the same as those in the embodiment 21, and will not be repeated here.

### Embodiment twenty-three

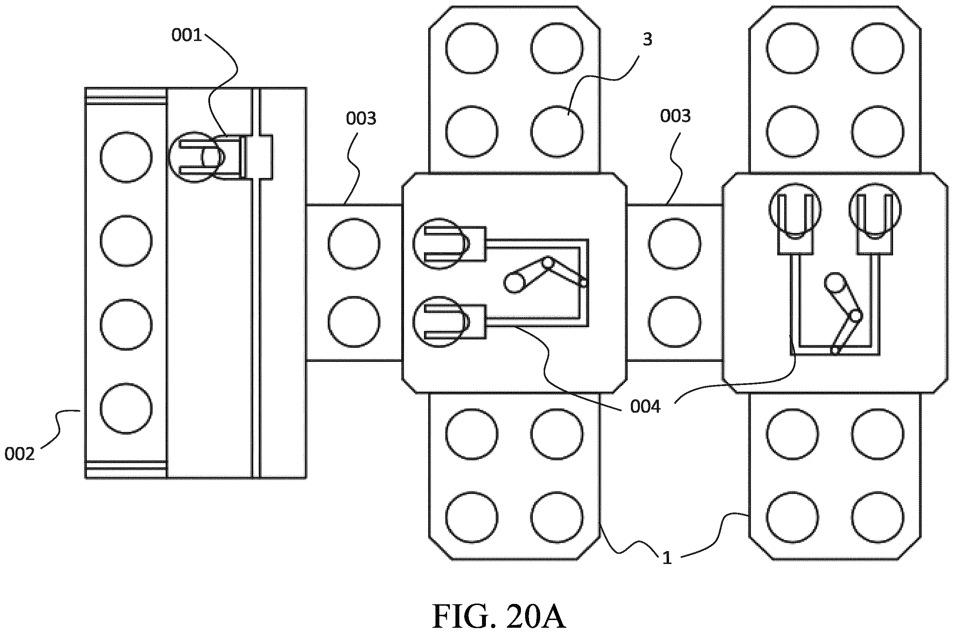

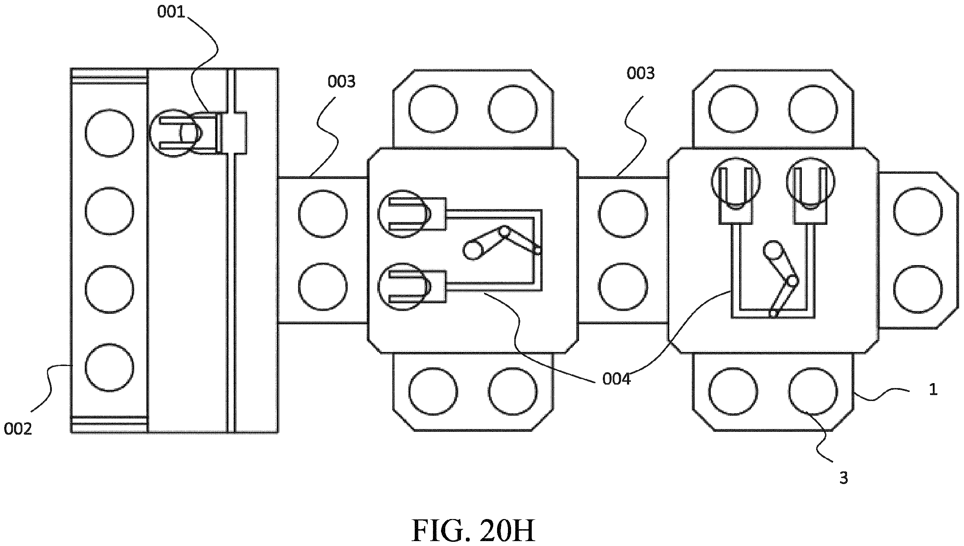

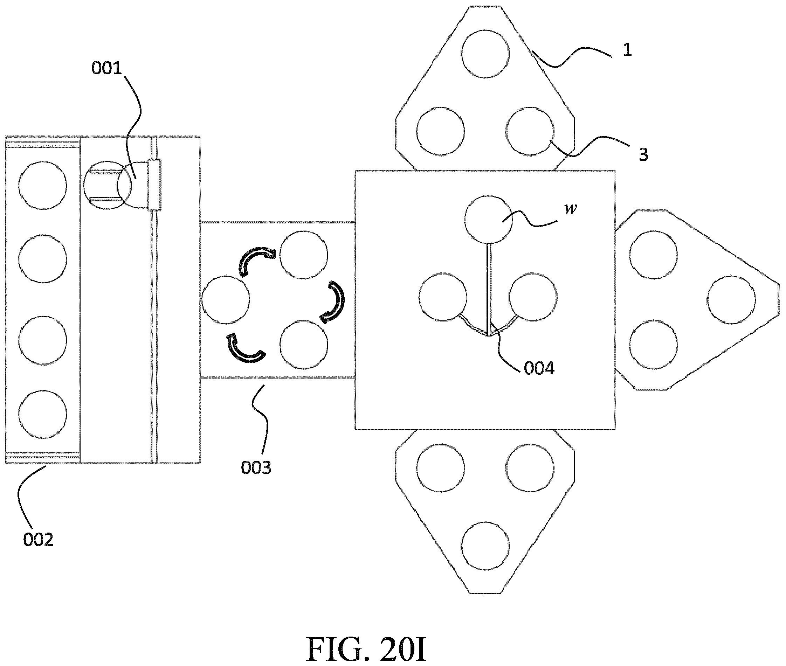

As shown in FIG. 20A to FIG. 20E, the embodiment 23 provides a thin film deposition apparatus, including: a substrate loading port 002 for placing a substrate w; a buffer device 003; a front-end manipulator 001 configured to transfer a substrate w between the substrate loading port 002 and the buffer device 003; the thin film deposition device in the above-mentioned embodiments 1-13 is used for thin film deposition on the substrate w; a process manipulator 004 configured to transfer the substrate w between the buffer device 003 and the processing chamber 1 of the thin film deposition device.

Specifically, the front-end robot 001 takes out the substrate w to be deposited from the substrate loading port 002 and places it on the buffer device 003; the manipulator 004 takes out the substrate w from the buffer device 003 and places it in the processing chamber 1 of the thin film deposition device for performing the thin film deposition on the surface of the substrate w; after the film deposition is completed, the process manipulator 004 takes the substrate w out of the processing chamber 1 and places it on the buffer device 003; the front-end manipulator 001 takes the substrate w out of the buffer device 003 and puts back the substrate loading port 002 to complete the process operation of the thin film deposition apparatus.

In the embodiment 23, as shown in FIG. 20A to FIG. 20C, there are multiple processing chambers 1 of the thin film deposition device, and the multiple processing chambers 1 are symmetrically arranged on both sides of the process manipulator 004.

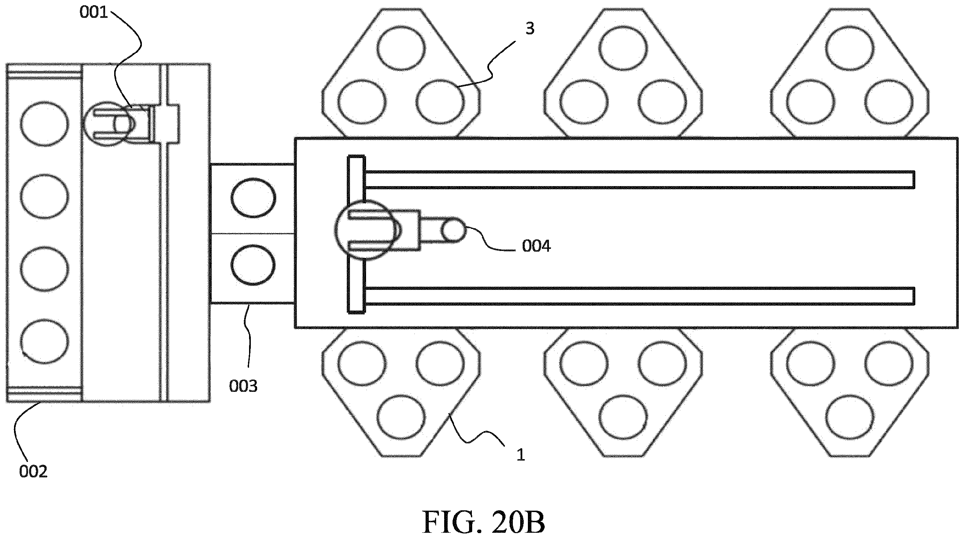

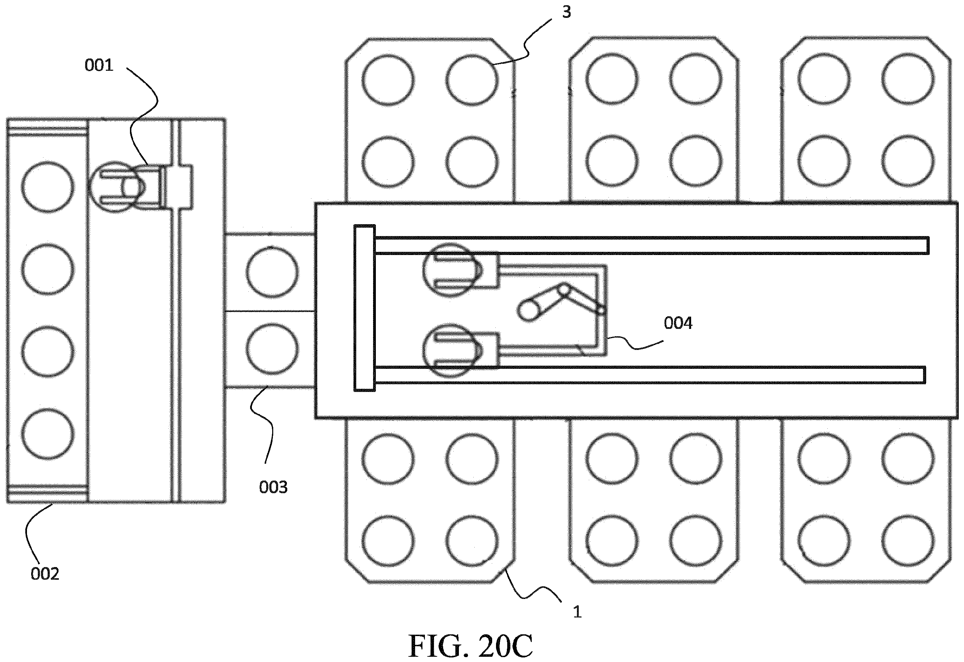

The numbers of process manipulators 004 is one or more. When there are multiple process manipulators 004, as shown in FIG. 20A, there are multiple corresponding buffer devices 003. When the process manipulator 004 is one, as shown in FIG. 20B and FIG. 20C, a non-contact magnetic levitation track is provided under the process manipulator 004 to ensure that the process manipulator 004 has no oil and no friction during the sliding process. A multiple of heating trays 3 may also be provided in each processing chamber 1 for performing thin film deposition on multiple substrates w at the same time, so as to improve the process efficiency of thin film deposition.

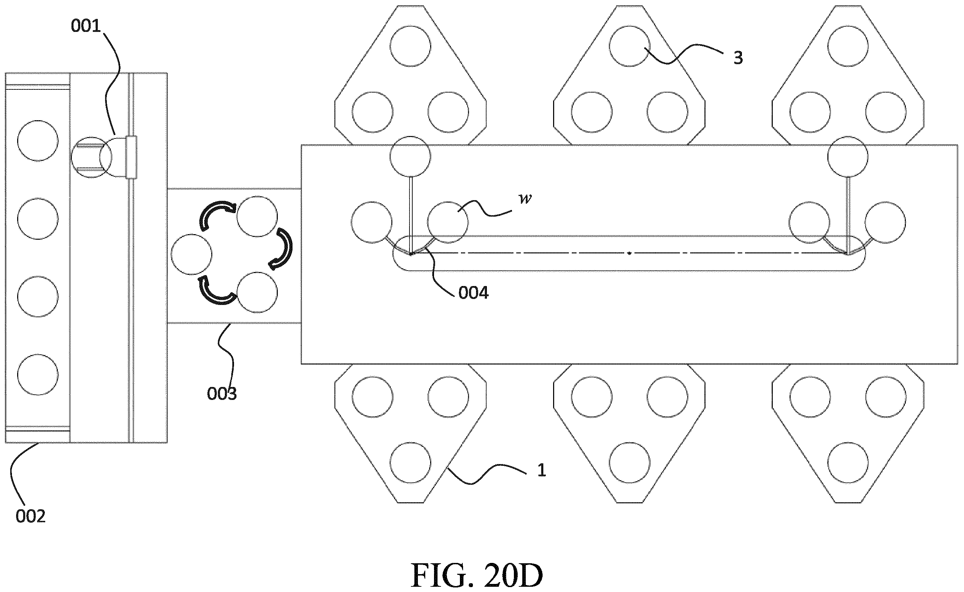

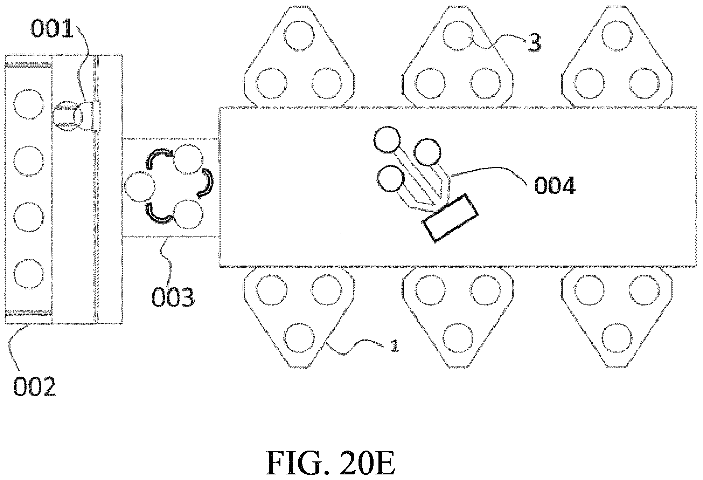

In the embodiment 23, as shown in FIG. 20A, FIG. 20C, multiple heating trays 3 in each processing chamber 1 can be arranged in a matrix structure. Or, in other implementations, as shown in FIG. 20B, FIG. 20D and FIG. 20E, a multiple of heating trays 3 in each processing chamber 1 are arranged in a triangular structure. The three heating trays in each processing chamber are arranged in an inverted triangle that one of heating trays is closer than the other two heating trays to the front-end robot.

Optionally, a multiple of substrates w can be placed in the buffer device 003, and the centers of the multiple of substrates w are on the same circle, and the multiple of substrates w may be rotated along a rotation shaft perpendicular to the center of the circle to change the w is the internal position of the buffer device 003.

As shown in FIG. 20D and FIG. 20E, three substrates w can be placed in the buffer device 003, and the three substrates w in the buffer device 003 are arranged in a triangular structure, and the three substrates w can be rotated. The structure of the process manipulator 004 matches the triangular structure formed by the three substrates w in the buffer device 003 and the triangular structure formed by the three heating trays 3 in the processing chamber 1. The process manipulator 004 includes three substrate transfer arms for picking and placing substrates, and the positions and numbers of the substrate transfer arms are set corresponding to the multiple of heating trays 3. The process manipulator 004 simultaneously takes three substrates w from the buffer device 003 and puts them on the three heating trays 3 of the processing chamber 1, so as to improve the process efficiency of thin film deposition.

Further, as shown in FIG. 20E, there is only one process manipulator 004. Process manipulator 004 is a retractable arm. At the same time, the process manipulator 004 can rotate and swing left and right to pick and place the substrate w in the processing chamber 1 at different positions.

### Embodiment twenty-four

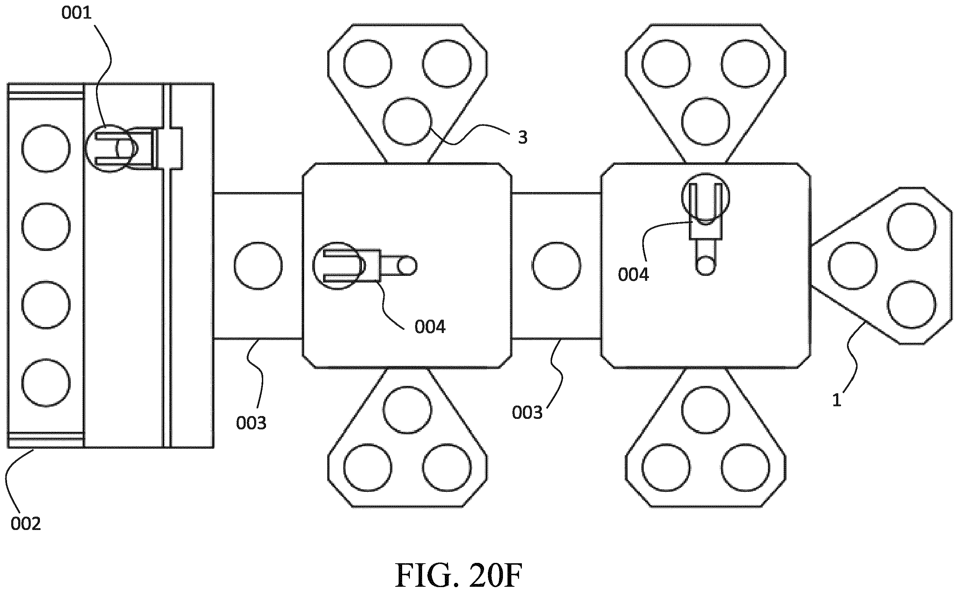

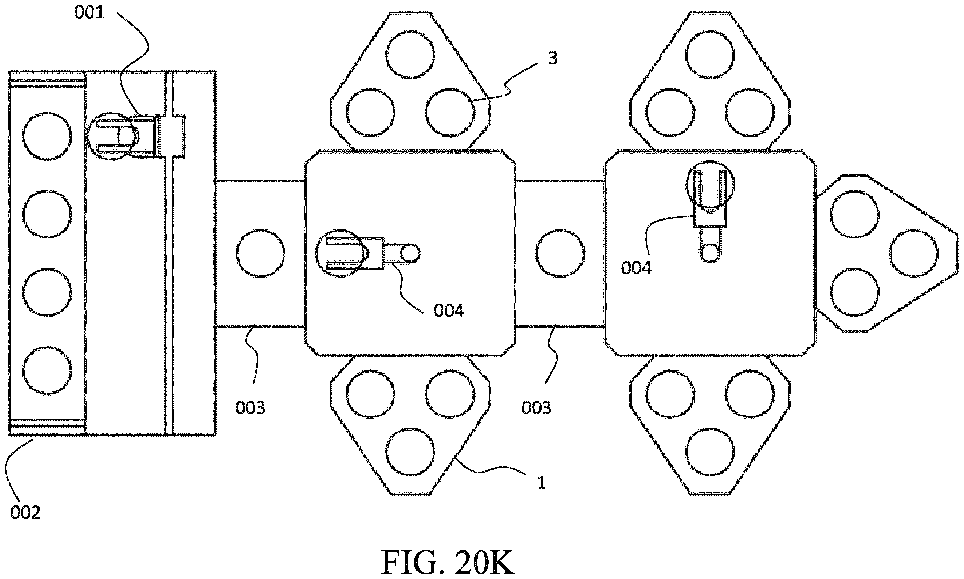

The embodiment 24 provides a kind of film deposition apparatus, compared with the embodiment 23, the difference is:
As shown in FIG. 20F to FIG. 20I as well as FIG. 20K, a multiple of processing chambers 1 are sequentially arranged on the periphery of the process manipulator 004.

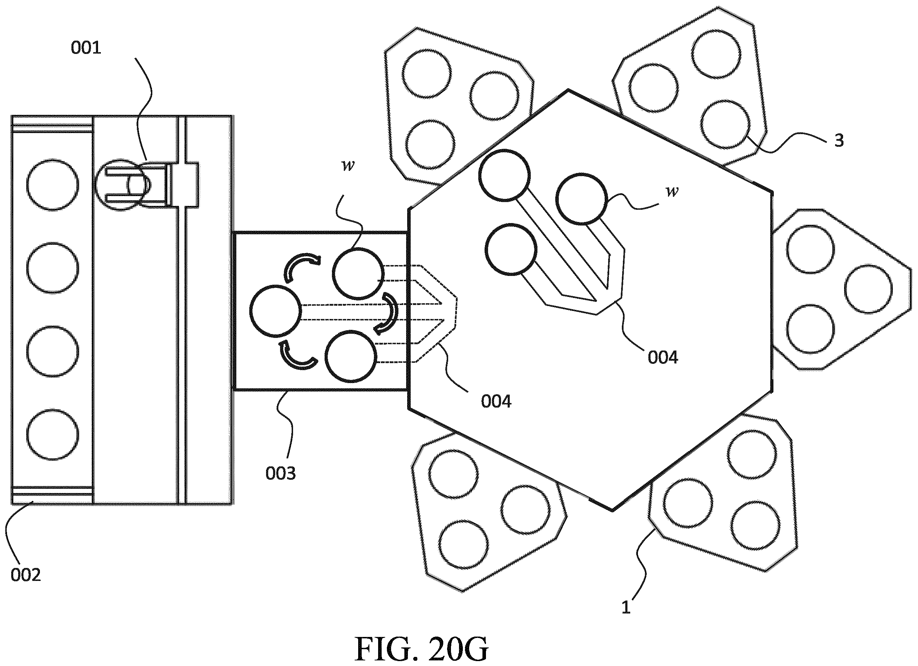

As shown in FIG. 20G, there are five processing chambers 1 arranged on the periphery of the process manipulator 004 in sequence. Each processing chamber 1 is provided with three heating trays 3 for simultaneous film deposition on three substrates w, and the three heating trays 3 are arranged in a triangular structure.

In a preferred embodiment, the buffer device 003 is provided with two storage platforms, and each storage platform can be configured to place three substrates w. One of the storage platforms is configured to place the substrate w to be deposited, and the deposited substrate w passed out through another layer of storage platform. The double-layer structure can reduce the waiting time of the substrate w, which is conducive to improving the throughput of machine apparatus. The storage platforms on the two floors can be unconnected, and two rotating units are configured to drive the respective storage platforms to rotate. The two-layer storage platforms can also be connected, and the two-layer storage platforms are placed on the same rotating unit, and a rotating shaft is configured to drive the two-layer storage platforms to rotate synchronously.

Based on the overall operating speed of the apparatus, optionally, the thin film deposition apparatus is provided with multiple buffer devices 003. The multiple buffer devices 003 can be communication with each other or not.

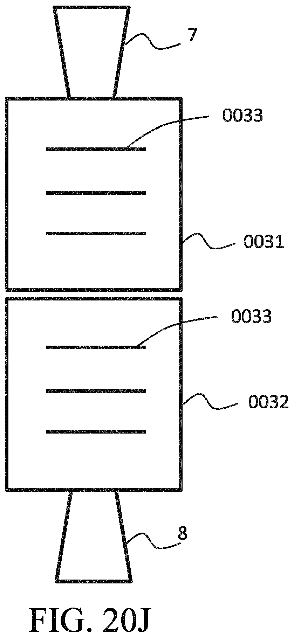

Preferably, as shown in FIG. 20J, the thin film deposition apparatus is provided with two buffer devices 003, which are buffer device 0031 and buffer device 0032 respectively. Each buffer device 003 is provided with three layers of storage platforms 0033 in the vertical direction, and each layer of storage platforms 0033 can be configured to place three substrates w. The buffer device 0031 is driven by the rotation unit 7, and the buffer device 0032 is driven by the rotation unit 8. The three-layer storage platform 0033 in each buffer device 003 is driven to rotate synchronously by a rotation unit. The two buffer devices 003 are laid out along the vertical direction, and the vertical distance between the two buffer devices 003 is within a preset range within which the process manipulator 004 can pick and place the substrate w. Optionally, one of the three-layer storage platforms 0033 can be vacant, and the other two storage platforms are configured to pick and place the substrate w. According to process requirements, the number of process manipulator 004 is not limited to one.

Further, one side of one buffer device 0031 is opened, and the front-end manipulator 001 takes out the substrate w to be deposited from the substrate loading port 002 and places it on the buffer device 0031. The other side of the buffer device 0032 is opened, and the deposited substrate w will be taken out by the process manipulator 004 from the processing chamber 1 and placed on the buffer device 0032. On the contrary, the other side of the buffer device 0032 is opened to place the substrate w to be deposited, and the other side of the buffer device 0031 is opened to place the deposited substrate w. That is, the opening modes of the buffer device 0031 and the buffer device 0032 are interleaved to improve production efficiency. Other settings in the embodiment 24 are the same as those in the embodiment 23, and will not be repeated here.

### Embodiment twenty-five

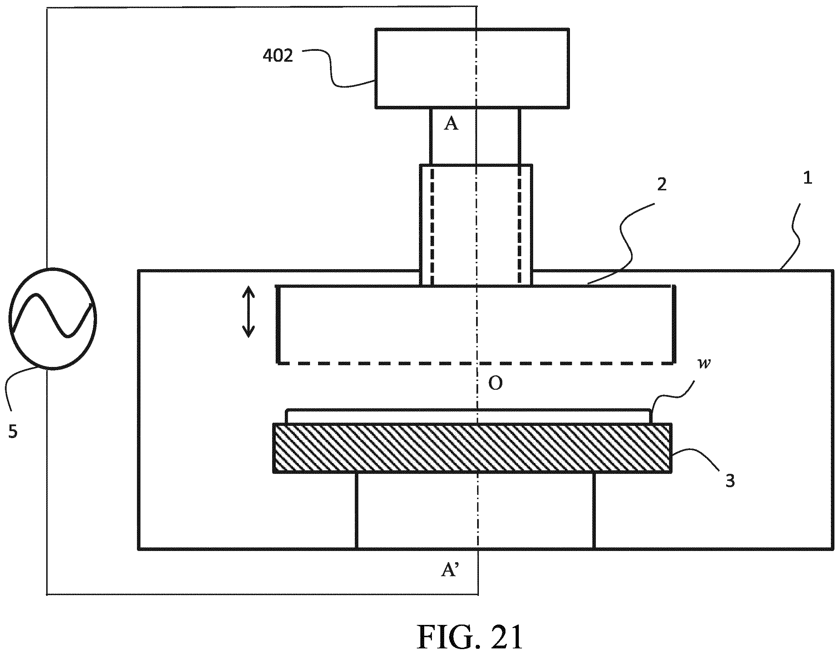

As shown in FIG. 21, the present embodiment 25 provides a thin film deposition device, the thin film deposition device comprises: a processing chamber 1 configured to perform thin film deposition; a gas supply assembly 2 arranged on the top wall of the processing chamber for supplying process gas to the in of the chamber 1; the heating tray 3 arranged below the gas supply assembly 2 for bearing and heating the substrate w; the radio frequency source 5 configured to provide radio frequency power to activate the process gas in the processing chamber 1 to dissociate into plasma, and the plasma is used for film deposition on the substrate w; the lifting member 402 connected to the gas supply assembly 2 for driving the gas supply assembly 2 to move up and down.

The lifting member 402 can be an air cylinder 402. The air cylinder 402 drives the gas supply assembly 2 to rise or fall to adjust the distance between the gas supply assembly 2 and the substrate w. The distance between the gas supply assembly 2 and the substrate w can be adjusted within a preset range to further improve the uniformity of film deposition of the PECVD layer stack structure.

The embodiment 25 can be combined with any one of the embodiments 1-13 to adjust the distance between the gas supply assembly 2 and the substrate w.

### Embodiment twenty-six

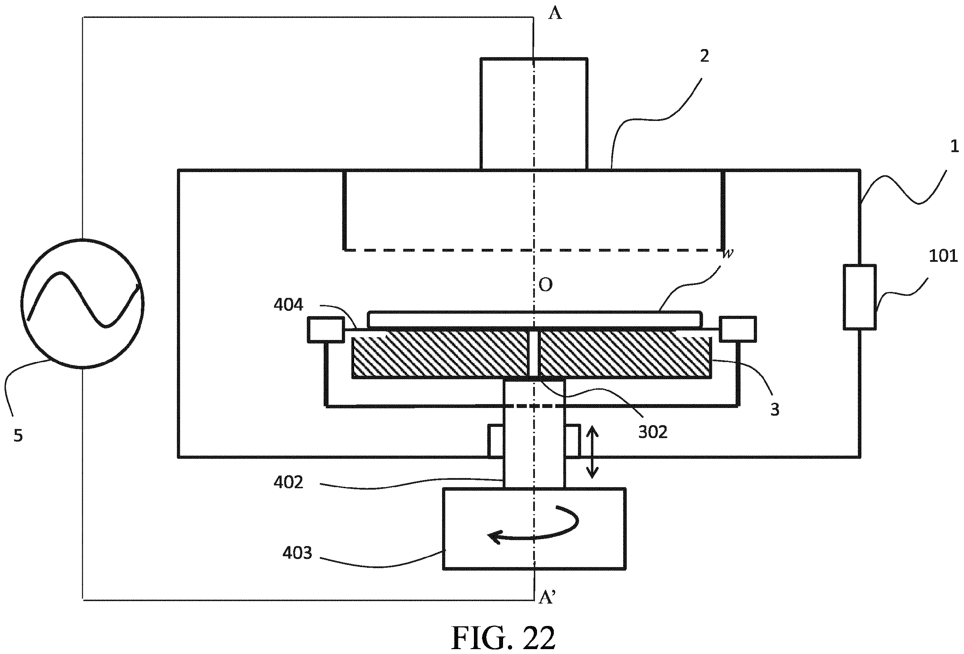

As shown in FIG. 22-23 , the embodiment 26 provides a thin film deposition device, and the thin film deposition device includes: a processing chamber 1 configured to perform thin film deposition; a gas supply assembly 2 arranged on the top wall of the processing chamber for supplying the process gas to the chamber 1; the heating tray 3 arranged below the gas supply assembly 2 for bearing and heating the substrate w; the radio frequency source 5 configured to provide radio frequency power to form a radio frequency electric field in the processing chamber 1 to activate the process gas in the chamber 1 dissociated into plasma, and the plasma performs thin film deposition on the substrate w; the rotating mechanism 403 connected to the heating tray 3 for driving the heating tray 3 to rotate around the rotation shaft AA' pass through the center of the substrate w .

The heating tray 3 can be lifted. The lifting member 402 is connected to the heating tray 3 for driving the heating tray 3 to rise or fall. The supporting member is configured to support the substrate w. The supporting member is a supporting ring 404 and/or an ejector pin 401.

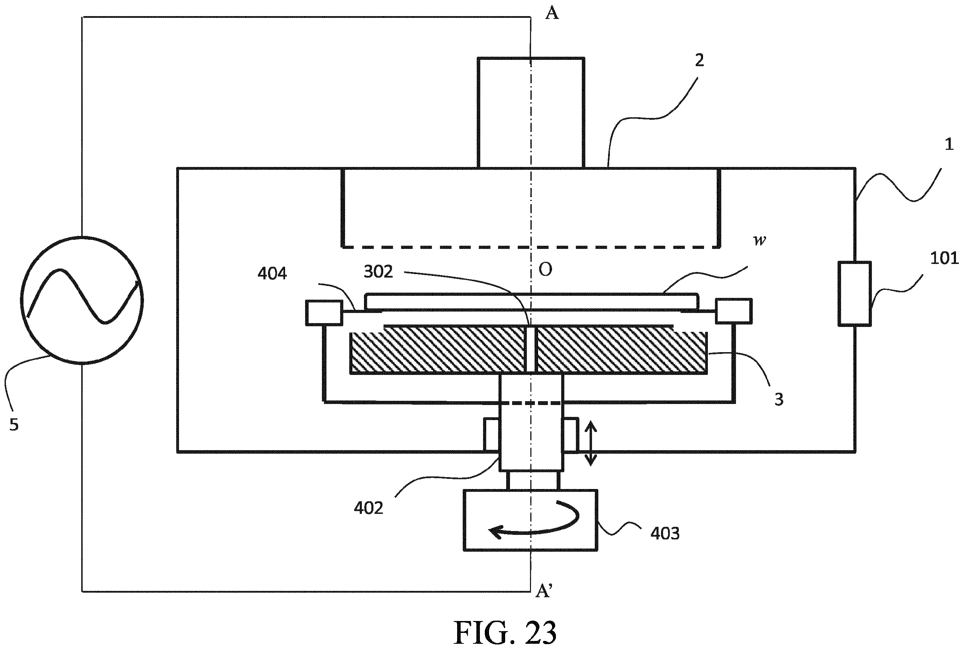

As shown in FIG. 23, when the heating tray 3 needs to be rotated, the lifting member 402 drives the heating tray 3 to move vertically downward, so that the heating tray 3 is separated from the substrate w, and the supporting member supports the substrate w. Then the rotating mechanism 403 drives the lifting member 420 to rotate with the heating tray 3 by a set angle. The heating tray 3 stops rotating after rotating the set angle, and the lifting member 402 drives the heating tray 3 to rise vertically to place the substrate w on the heating tray 3 for thin film deposition.

In addition, when the distance between the gas supply assembly 2 and the substrate w needs to be adjusted, the heating tray 3 rises or falls together with the substrate w, so that the distance value is within a preset range. It improvs the uniformity of the film deposition of the PECVD layer stack structure.

### Embodiment twenty-seven

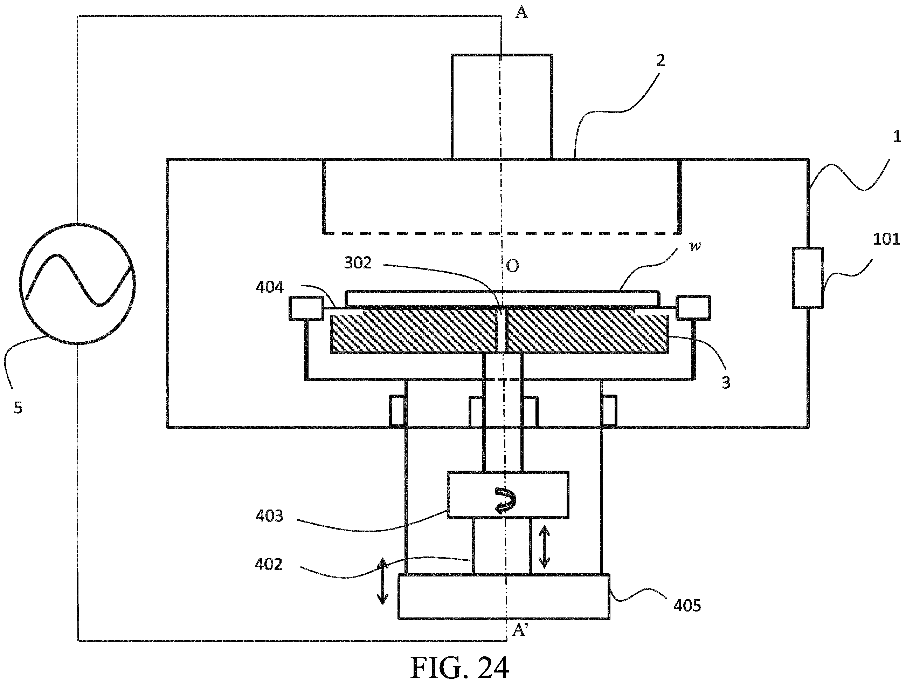

As shown in FIG. 24-25, the embodiment 27 provides a thin film deposition device, compared with the embodiment 26, the difference is:
The thin film deposition device further includes: a supporting member and a second lifting member 405. The supporting member is configured to support the substrate w, wherein the supporting member is a supporting ring 404 arranged at the bottom of the edge of the substrate w, and the supporting ring 404 adopts a circular ring with notch as shown in FIG. 5.

The first lifting member 402 is connected to the rotating mechanism 403 for driving the rotating mechanism 403 and the heating tray 3 to rise or fall. The rotating mechanism 403 is provided at the bottom of the heating tray 3 for driving the heating tray 3 to rotate around the shaft AA' passing through the center of the substrate w, so as to drive the substrate w to rotate synchronously.

The second lifting member 405 is connected to the supporting ring 404 for driving the supporting ring 404 to rise or fall vertically to lift the substrate w away from the heating tray 3 or place the substrate w on the heating tray 3. In addition, the second lifting member 405 is also connected to the first lifting member 402, and the second lifting member 405 drives the first lifting member 402 and the supporting ring 404 to move up and down together to drive the substrate w to move up and down to adjust the distance between the gas supply assembly 2 and the substrate w.

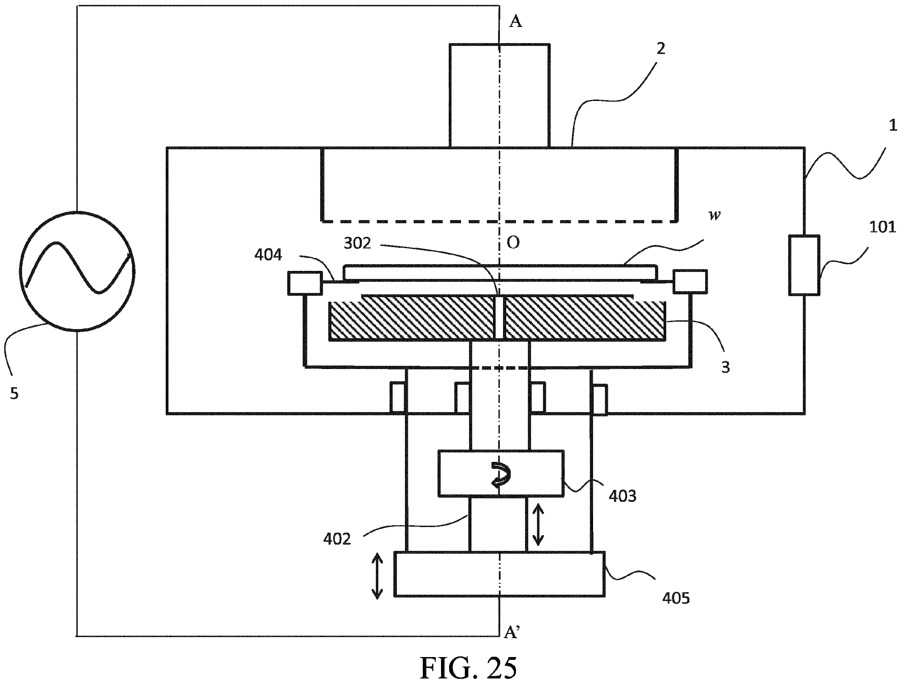

In this embodiment as shown in FIG. 25, when the heating tray 3 needs to be rotated, the second lifting member 405 drives the supporting ring 404 to lift up in the vertical direction to lift the substrate w and separate the substrate w from the heating tray 3. Then the rotating mechanism 403 drives the first lifting member 402 and the heating tray 3 to rotate a set angle. After the heating tray 3 rotates to a set angle and stops, the second lifting member 405 drives the supporting ring 404 to move downward in the vertical direction to place the substrate w on the heating tray 3 for thin film deposition. Optionally, the first lifting member 402 drives the heating tray 3 down so that the substrate w is detached from the heating tray 3.

The supporting member is an ejector pin moving in the vertical direction, and the heating tray 3 is provided with a first through hole, and the ejector pin is arranged in the first through hole. The second lifting member 405 drives the ejector pin to rise or fall vertically.

### Embodiment twenty-eight

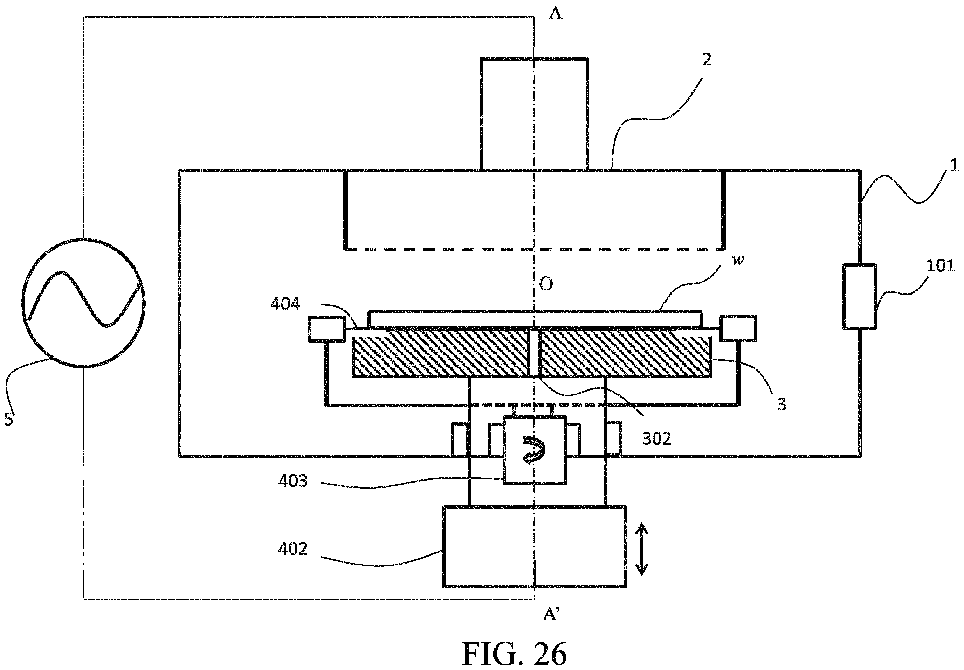

As shown in FIG. 26-27 , the embodiment 28 provides a thin film deposition device, and the thin film deposition device includes: a processing chamber 1 configured to perform thin film deposition; a gas supply assembly 2 arranged on the top wall of the processing chamber for supplying process gas to the chamber 1; a heating tray 3 arranged below the gas supply assembly 2 for bearing and heating the substrate w; a radio frequency source 5 configured to provide radio frequency power to form a radio frequency electric field in the processing chamber 1 to activate the process gas in the chamber 1 to dissociate into plasma, and the plasma performs thin film deposition on the substrate w; a lifting member 402 connected with the heating tray 3 for driving the heating tray 3 to move up and down.

The controller is connected to the gas supply assembly 2, the radio frequency source 5, the heating tray 3, the rotating mechanism 403 and the lifting member 402 respectively for controlling the gas supply assembly 2, the radio frequency source 5, the heating tray 3, the rotating mechanism 403 and the lifting member 402 to work. The controller is also configured to build a program menu that includes keeping the radio frequency source 5 at a on state while the substrate w is rotating.

The thin film deposition apparatus further includes: a supporting member configured to support the substrate w; a rotating mechanism 403 connected to the supporting member for driving the supporting member and the substrate w to rotate.

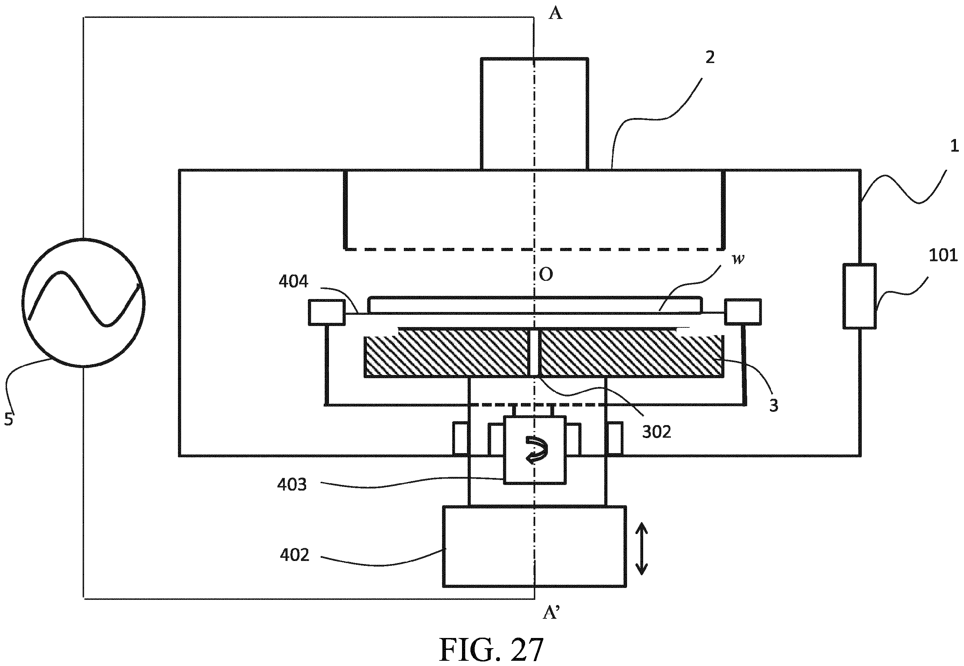

As shown in FIG. 27, the supporting member is a supporting ring 404, which is arranged at the bottom of the edge of the substrate w. The rotating mechanism 403 is connected to the supporting ring 404for driving the supporting ring 404 to rotate around the center line AA' of the substrate w as the rotation shaft.

When the substrate w needs to be rotated, the lifting member 402 drives the heating tray 3 fall vertically to separate the heating tray 3 from the supporting ring 404. The supporting ring 404 supports the substrate w, and the rotating mechanism 403 drives the supporting ring 404 to rotate. The supporting ring 404 holds the substrate w up to adjust the substrate w to rotate a set angle to realize the rotation of the substrate w around the rotation shaft AA', which compensates for the uneven thickness of the film deposited on the substrate w and realizes the uniformity and stability of the film deposition of the PECVD layer stack structure.

### Embodiment twenty-nine

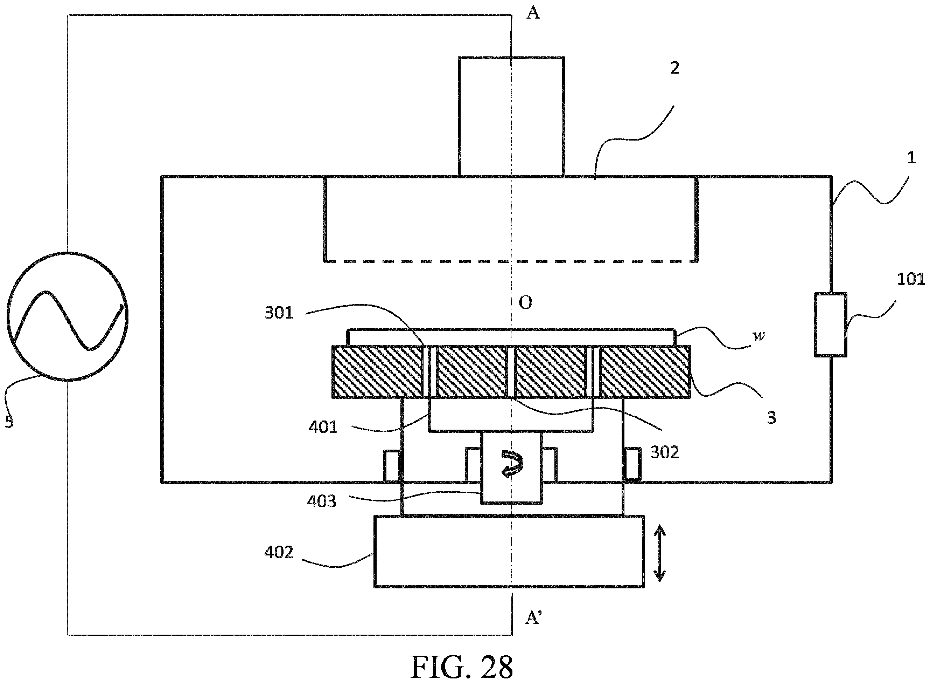

As shown in FIG. 28-29, the embodiment 29 provides a thin film deposition device, compared with the embodiment 28, the difference is:
The supporting member is an ejector pin 401, and the heating tray 3 is provided with a first through hole 301, and the ejector pin 401 is arranged in the first through hole 301. As shown in FIG. 3A and FIG. 3B, the cross-section of the first through hole 301 on the horizontal plane is arc-shaped or circular, and the center M of the arc-shaped or circular shape is on a vertical line with the center O of the substrate w. When the substrate w needs to be rotated, the lifting member 402 drives the heating tray 3 down in the vertical direction to separate the heating tray 3 from the substrate w, and the ejector pin 401 lifts the substrate w. The ejector pin 401 supports the substrate w, and the rotating mechanism 403 drives the ejector pin 401 to move along an arc-shaped track in the first through hole 301 t. After the substrate w rotates by a set angle, the substrate w stops rotating, and the lifting member 402 drives the heating tray 3 to rise vertically to place the substrate w on the heating tray 3 for subsequent film deposition.

### Embodiment thirty

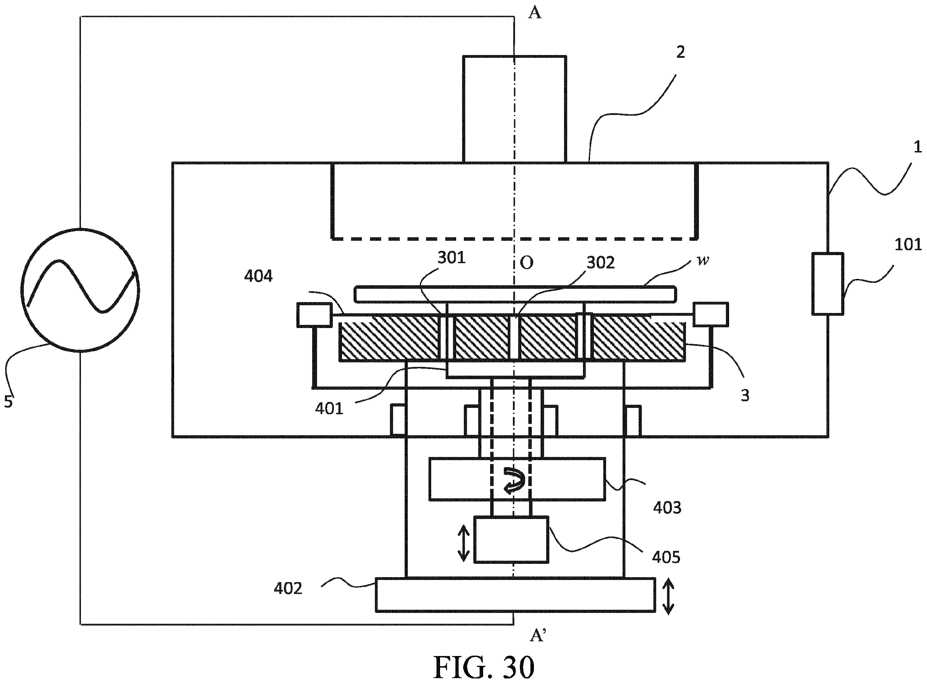

As shown in FIG. 30-31, the embodiment 30 provides a thin film deposition device, compared with the embodiment 28, the difference is:
The supporting member includes an ejector pin 401 and a supporting ring 404. The film deposition device includes a first lifting member 402 and a second lifting member 405. The first lifting member 402 is connected to the heating tray 3 for driving the heating tray 3 to move up and down. The second lifting member 405 is connected to the ejector pin 401 for driving the ejector pin 401 to rise or fall vertically to allow the manipulator to remove the substrate w from the heating tray 3 or to place the substrate w on the heating tray 3.

### Embodiment thirty-one

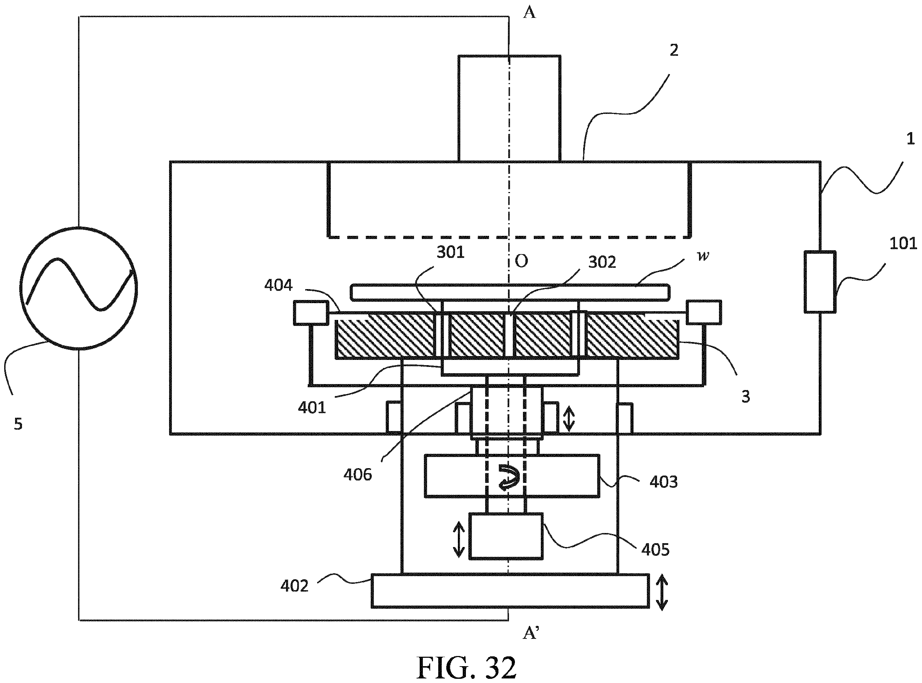

As shown in FIG. 32-33, the embodiment 31 provides a thin film deposition device, compared with the embodiment 30, the difference is:
The thin film deposition device further includes a third lifting member 406, and the third lifting member 406 is connected to the supporting ring 404.

In this embodiment, the second lifting member 405 drives the ejector pin 401 to rise or fall vertically to remove the substrate w from the heating tray 3 or place the substrate w on the heating tray 3 by the manipulator. The first lifting member 402 drives the heating tray 3 to move up and down, and the third lifting member 406 drives the supporting ring 404 and the substrate w to move up and down. The heating tray 3 and the substrate w move synchronously under the drive of the first lifting member 402 and the third lifting member 406 respectively to adjust the distance between the gas supply assembly 2 and the substrate w, so that the distance value is within a preset range value, which further improvs the uniformity of film deposition of PECVD layer stack structure. Optionally, the third lifting member 406 is connected to the first lifting member 402 and the supporting ring 404 respectively, and the third lifting member 406 drives the first lifting member 402 and the supporting ring 404 to move up and down along the vertical direction.

When the substrate w needs to be rotated, the third lifting member 406 drives the supporting ring 404 to rise vertically till the supporting ring 404 is separated from the heating tray 3. The supporting ring 404 supports the substrate w, and the rotating mechanism 403 drives the supporting ring 404 to rotate, and the supporting ring 404 hold up the substrate w to adjust the substrate w to rotate the set angle.

### Embodiment thirty-two

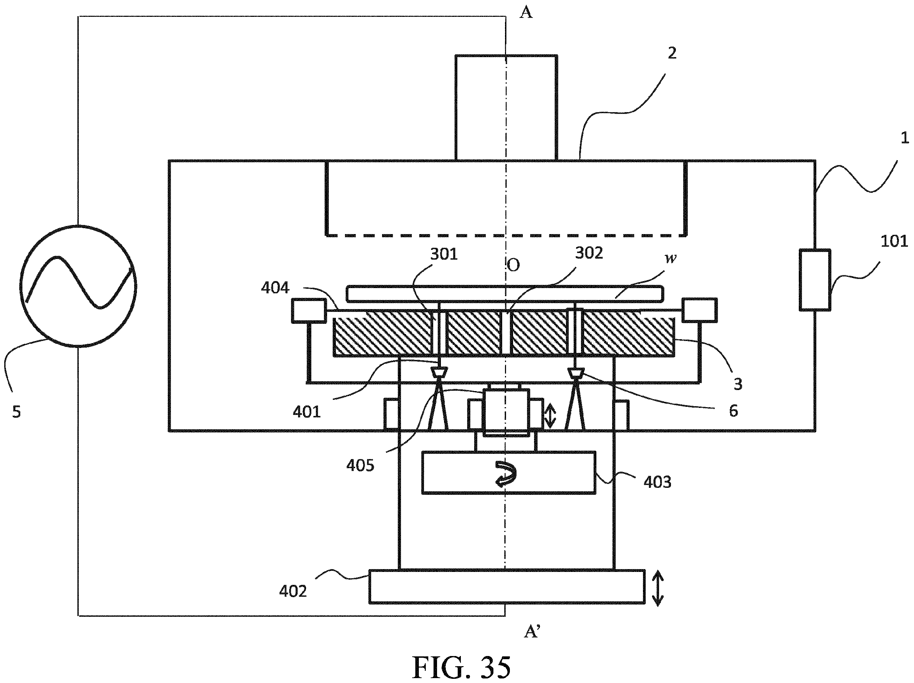

As shown in FIG. 35-36, the embodiment 32 provides a thin film deposition device, compared with the embodiment 28, the difference is: the thin film deposition device further includes an ejector pin 401 and a second lifting member 405, and the lifting member 402 is the first lifting member 402.

The first lifting member 402 drives the heating tray 3 to move, and the second lifting member 405 is connected to the supporting ring 404 for driving the supporting ring 404 to rise or fall vertically. The heating tray 3 is provided with a first through hole 301, and the ejector pin 401 is arranged in the first through hole 301. The lower end of the ejector pin 401 abuts against the base 6, and the base 6 is connected to the bottom of the processing chamber 1. According to the height of the substrate w transported into the processing chamber 1, the height of the base 6 is preset. When the ejector pin 401 abuts on the base 6, the upper end of the ejector pin 401 is higher than the supporting ring 404 and the heating tray 3, and the upper end of the ejector pin 401 is used for receiving substrate w.

The heating tray 3 and the substrate w move synchronously under the driving of the first lifting member 402 and the second lifting member 405 to adjust the distance between the gas supply assembly 2 and the substrate w. In one embodiment, the heating tray 3 is provided with a groove corresponding to the position of the ejector pin 401, and the top of the ejector pin 401 is provided with a convex portion. When the heating tray 3 moves upward, the convex portion of the ejector pin 401 is accommodated in the groove. The heating tray 3 continues to move upward and take the ejector pin 401 to move upward together. After the ejector pin 401 moves upward, the ejector pin 401 is separated from the base 6, and the ejector pin 401 is in a suspended state.

When the substrate w needs to be rotated, the second lifting member 405 drives the supporting ring 404 to rise vertically, and the supporting ring 404 is separated from the heating tray 3. The supporting ring 404 supports the substrate w, and the rotating mechanism 403 drives the supporting ring 404 to rotate to adjust the substrate w to rotate the set angle.

### Embodiment thirty-three

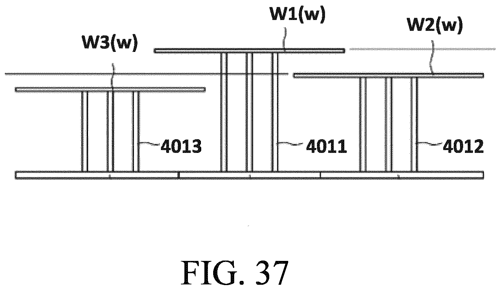

As shown in FIG. 37, the embodiment 33 provides a thin film deposition device, the thin film deposition device includes: a processing chamber 1 configured to perform thin film deposition; a gas supply assembly 2 arranged on the top wall of the processing chamber 1 for supplying process gas to the chamber 1; a heating tray 3 arranged below the gas supply assembly 2 for bearing and heating the substrate w; a radio frequency source 5 configured to provide radio frequency power to activate the process gas in the processing chamber 1 to dissociate into plasma, the plasma performs thin film deposition on the substrate w; a ejector pin 401 arranged in the heating tray 3, one end of the ejector pin 401 is set at the bottom of the processing chamber 1 , and the other end of the ejector pin 401 is configured to receive the substrate w.

In this embodiment, each processing chamber 1 is provided with three heating trays 3 for performing thin film deposition on three substrates w simultaneously. The thin film deposition device includes three sets of ejector pins. Each set of ejector pins includes three ejector pins 401, and each ejector pins 401 have the same height for receiving a substrate w. Each set of ejector pins has a different height.

Preferably, the heights of the three sets of ejector pins are stepped, and the received substrate w is correspondingly configured in a stepped shape. Three heating trays 3 are arranged in a triangular structure. The structure of the process manipulator 004 matches the triangular structure formed by the three heating trays 3 in the processing chamber 1. The process manipulator 004 respectively places three substrates w according to the heights of the three sets of ejector pins from high to low. Specifically, such as FIG. 37, align the substrate w1 with the heating tray 3 corresponding to the ejector pin 4011 firstly, and place the substrate w1 on the heating tray 3 after the centering is completed, then place the substrate w2 after aligning the substrate w2 with the heating tray 3 corresponding to the ejector pin 4012. Similarly, the substrate w3 is firstly aligned with the heating tray 3 corresponding to the ejector pin 4013 and then placed on the heating tray 3. The alignment accuracy of the three substrates w and the respective heating trays 3 is improved through the above arrangement. In addition, the ejector pin 401 can be centered without lifting and lowering, which simplifies the structure of the thin film deposition device.

It should be noted that, under the condition that the logic of the technical solution is correct, the above-mentioned multiple embodiments can be combined to form a new solution, that is, certain features, structures or characteristics in one or more embodiments of the present application can be appropriately combined. The new scheme will not be described in detail here.

Through the description of the above embodiments and related drawings, the present invention has specifically and detailly disclosed related technologies, so that those skilled in the art can implement them accordingly. The above-mentioned embodiments are only used to illustrate the present invention, rather than to limit the present invention, and the scope of rights of the present invention should be defined by the claims of the present invention. Changes in the number of elements described herein or substitution of equivalent elements should still fall within the scope of the present invention.

Meanwhile, the present invention uses specific words to describe the embodiments of the present invention. For example, "one embodiment", "an embodiment", and/or "some embodiments" means a certain feature, structure or characteristic related to at least one embodiment of the present invention. Therefore, it should be emphasized and noted that two or more references to "an embodiment" or "an embodiment" or "an alternative embodiment" in different places in this specification do not necessarily refer to the same embodiment.

Similarly, it should be noted that in order to simplify the description of the disclosure of the present invention and thus help the understanding of one or more embodiments of the invention, in the foregoing descriptions of the embodiments of the present invention, sometimes multiple features are combined into one embodiment, drawings or descriptions thereof. This method of disclosure, however, does not imply that the inventive subject matter requires more features than are recited in the claims. Indeed, embodiment features are less than all features of a single foregoing disclosed embodiment.

## Claims

1. A thin film deposition device, comprising:
a processing chamber configured for thin film deposition;
a gas supply assembly arranged on the top wall of the processing chamber for supplying process gas to the processing chamber;
a heating tray arranged below the gas supply assembly for bearing and heating a substrate;
a radio frequency source for providing radio frequency power to activate the process gas in the processing chamber to dissociate into plasma and deposit a thin film on the substrate;
a rotating mechanism for controlling the rotation of the substrate, or the rotation of the heating tray, or the synchronous rotation of the substrate and the heating tray, the rotation shaft of the rotating mechanism being perpendicular to the substrate and passing through the substrate;
wherein the radio frequency source is kept in an on state during the rotating mechanism rotating the substrate, or the heating tray, or the substrate and the heating tray.

2. A thin film deposition device, comprising:
a processing chamber configured for thin film deposition;
a gas supply assembly arranged on the top wall of the processing chamber for supplying process gas to the processing chamber;
a heating tray arranged below the gas supply assembly for bearing and heating a substrate;
a radio frequency source for providing radio frequency power to activate the process gas in the chamber to dissociate into plasma and deposit a thin film on the substrate;
a rotating mechanism for controlling the rotation of the substrate, the rotation shaft of the rotating mechanism being perpendicular to the substrate and passing through the substrate;
a supporting member for supporting the substrate;
a lifting member connected to the supporting member for driving the supporting member to rise or fall in the vertical direction to lift the substrate away from the heating tray or place the substrate on the heating tray;
wherein the rotating mechanism is arranged at the bottom of the lifting member and configured for driving the supporting member and the lifting member to rotate synchronously along the horizontal circumferential direction to rotate the substrate.

3. The thin film deposition device of claim 2, wherein the supporting member is an ejector pin moving along the vertical direction and the horizontal circumferential direction;
the heating tray is provided with a first through hole, and the ejector pin is arranged in the first through hole; and
the section of the first through hole on the horizontal plane is arc-shaped or circular, and the center of the arc-shaped or circular circle is on a vertical line with the center of the substrate;
when the substrate needs to be rotated, the lifting member drives the ejector pin to rise vertically and protrude from the first through hole to lift the substrate so that the substrate is separated from the heating tray, and the rotating member drives the ejector pin to move along an arc-shaped trajectory in the first through hole to rotate the substrate at a set angle;
after the substrate rotates at a set angle, the substrate stops rotating, and the lifting member drives the ejector pin to move down in a vertical direction to place the substrate on the heating tray for thin film deposition.

4. The thin film deposition device of claim 3, wherein the number of the ejector pins is at least three, and the number of the first through holes is at least three, and the first through holes correspond to the ejector pins one by one.

5. The thin film deposition device of claim 2, wherein the supporting member is a supporting ring arranged at the bottom of the edge of the substrate; and
the supporting ring is lifted up or down in the vertical direction and rotated with the center shaft of the substrate as the shaft of rotation;
when the substrate needs to be rotated, the lifting member drives the supporting ring to lift up in the vertical direction to life the substrate and separate the substrate from the heating tray, and the rotating member drives the supporting ring to rotate to rotate the substrate by a set angle;
after the substrate rotates to a set angle, stop rotation, and the lifting member drives the supporting ring to lift down in the vertical direction to place the substrate on the heating tray for thin film deposition.

6. The thin film deposition device of claim 5, wherein the supporting ring is a circular ring with a notch, or the supporting ring includes multiple arc-shaped structures of a ring.

7. A thin film deposition device, comprising:
a processing chamber configured for thin film deposition;
a gas supply assembly arranged on the top wall of the processing chamber for supplying process gas to the processing chamber;
a heating tray arranged below the gas supply assembly for bearing and heating a substrate;
a radio frequency source for providing radio frequency power to activate the process gas in the chamber to dissociate into plasma gas and deposit a thin film on the substrate;
a rotating mechanism for controlling the rotation of the substrate, the rotation shaft of the rotating mechanism being perpendicular to the substrate and passing through the substrate;
a supporting member including an ejector pin and a supporting ring for supporting the substrate;
a first lifting member connected to the ejector pin and configured for driving the ejector pin to rise or fall in the vertical direction to load or unload the substrate;
a second lifting member connected to the supporting ring and configured for driving the supporting ring to rise or fall in the vertical direction to lift the substrate away from the heating tray or place the substrate on the heating tray;
wherein the rotating mechanism is arranged at the bottom of the second lifting member which configured to drive the supporting ring and the second lifting member to rotate to drive rotate the substrate; and
the heating tray is provided with a first through hole, and the ejector pin is arranged in the first through hole.

8. A thin film deposition device, comprising:
a processing chamber configured for thin film deposition;
a gas supply assembly arranged on the top wall of the processing chamber for supplying process gas to the processing chamber;
a heating tray arranged below the gas supply assembly for bearing and heating a substrate;
a radio frequency source for providing radio frequency power to activate the process gas in the chamber to dissociate into plasma gas and deposit a thin film on the substrate;
a rotating mechanism for controlling the synchronous rotation of the substrate and the heating tray, the rotation shaft of the rotating mechanism being perpendicular to the substrate and passing through the substrate;
wherein the rotating mechanism is connected to the heating tray and configured for driving the heating tray to rotate with the center shaft of the substrate as the shaft of rotation to drive the substrate to rotate synchronously.

9. A thin film deposition device, comprising:
a processing chamber configured for thin film deposition;
a gas supply assembly arranged on the top wall of the processing chamber for supplying process gas to the processing chamber;
a heating tray arranged below the gas supply assembly for bearing and heating a substrate;
a radio frequency source for providing radio frequency power to activate the process gas in the chamber to dissociate into plasma and deposit a thin film on the substrate;
a rotating mechanism for controlling the rotation of the heating tray, the rotation shaft of the rotating mechanism being perpendicular to the substrate and passing through the substrate;
a supporting member for supporting the substrate;
a lifting member connected to the supporting member and configured for driving the supporting member to rise or fall in the vertical direction to lift the substrate away from the heating tray or place the substrate on the heating tray;
wherein the rotating mechanism is connected to the heating tray and configured for driving the heating tray to rotate around the center shaft of the substrate as the shaft of rotation.

10. A thin film deposition device, comprising:
a processing chamber configured for thin film deposition;
a gas supply assembly arranged on the top wall of the processing chamber for supplying process gas to the processing chamber;
a heating tray arranged below the gas supply assembly for bearing and heating a substrate;
a radio frequency source for providing radio frequency power to activate the process gas in the chamber to dissociate into plasma and deposit a thin film on the substrate;
a rotating mechanism for controlling the rotation of the heating tray, the rotation shaft of the rotating mechanism being perpendicular to the substrate and passing through the substrate;
a supporting member for supporting the substrate;
a lifting member connected to the heating tray and configured for driving the heating tray to rise or fall;
wherein the rotating mechanism is connected to the lifting member and configured for driving the lifting member and the heating tray to rotate around the center shaft of the substrate as the shaft of rotation.

11. A thin film deposition device, comprising:
a processing chamber configured for thin film deposition;
a gas supply assembly arranged on the top wall of the processing chamber for supplying process gas to the processing chamber;
a heating tray arranged below the gas supply assembly for bearing and heating a substrate;
a radio frequency source for providing radio frequency power to activate the process gas in the chamber to dissociate into plasma and deposit a thin film on the substrate;
a rotating mechanism connected to the heating tray and configured for controlling the rotation of the heating tray, the rotation shaft of the rotating mechanism being perpendicular to the substrate and passing through the substrate;
a first lifting member connected to the rotating member and configured for driving the rotating member and the heating tray to rise or fall;
a second lifting member connected to the supporting member and the first lifting member respectively for driving the supporting member and the first lifting member to rise or fall in vertical direction.

12. A thin film deposition device, comprising:
a processing chamber configured for thin film deposition;
a gas supply assembly arranged on the top wall of the processing chamber for supplying process gas to the processing chamber;
a heating tray arranged below the gas supply assembly for bearing and heating a substrate;
a radio frequency source for providing radio frequency power to activate the process gas in the chamber to dissociate into plasma and deposit a thin film on the substrate;
a rotating mechanism for controlling the rotation of the substrate, the rotation shaft of the rotating mechanism being perpendicular to the substrate and passing through the substrate;
a lifting member connected to the heating tray and configured for driving the heating tray to rise or fall in vertical direction;
a supporting member for supporting the substrate;
wherein the rotating mechanism drives the supporting member to rotate synchronously with the substrate.

13. The thin film deposition device of claim 12, wherein the supporting member is a supporting ring arranged at the bottom of the edge of the substrate;
when the substrate needs to be rotated, the lifting member drives the heating tray to fall in vertical direction, the supporting ring lifts the substrate to make the substrate separate from the heating tray, and the rotating member drives the supporting ring to rotate at a set angle.

14. The thin film deposition device of claim 12, wherein the supporting member is an ejector pin moving in a horizontal circular direction;
the heating tray is provided with a first through hole, and the ejector pin is arranged in the first through hole; and
the section of the first through hole on the horizontal plane is arc-shaped or circular, and the center of the arc-shaped or the center of the circular is on a vertical line with the center of the substrate;
when the substrate needs to be rotated, the lifting member drives the heating tray to fall in vertical direction, and the ejector pin lifts the substrate to separate the substrate from the heating tray, and the rotating member drives the ejector pin to rotate at a set angle.

15. The thin film deposition device of claim 12, wherein the lifting member is a first lifting member, and the supporting member is a supporting ring, and the thin film deposition device further includes a second lifting member and an ejector pin; and
the second lifting member is connected to the ejector pin for driving the ejector pin to rise or fall in vertical direction to load or unload the substrate.

16. The thin film deposition device of claim 15, further comprising a third lifting member which is connected to the supporting ring for driving the supporting ring to rise or fall in vertical direction to lift the substrate away from the heating tray or place the substrate on the heating tray.

17. The thin film deposition device of claim 12, wherein the lifting member is a first lifting member, and the supporting member is a supporting ring, and the thin film deposition device further includes a second lifting member, an ejector pin and a base;
the second lifting member connected to the supporting ring for driving the supporting ring to rise or fall in the vertical direction; and
the heating tray is provided with a first through hole, and the ejector pin is arranged in the first through hole, and the base is arranged at the bottom of the processing chamber so that the ejector pin is movably arranged on the base;
when the ejector pin supporting the substrate, the lower end of the ejector pin abuts against the base, and the upper end of the ejector pin protrudes from the upper surface of the heating tray;
when the heating tray needs to be moved upwards, the upper end of the ejector pin is accommodated in the heating tray and moves together with the heating tray to break away from the base.

18. The thin film deposition device of claim 2, 7 or 12, wherein the radio frequency source is kept in an on state while the rotating member rotate the substrate.

19. The thin film deposition device of claim 18, wherein the gap between the substrate and the heating tray being adjusted to be smaller than a set value m, 0<m≤ 5mm.

20. The thin film deposition device of claim 9, 10 or 11, wherein the radio frequency source is kept in an on state while the rotating member rotate the heating tray.

21. The thin film deposition device of claim 20, wherein the gap between the substrate and the heating tray being adjusted to be smaller than a set value m, where 0<m≤5mm.

22. The thin film deposition device of claim 1, wherein the gap between the substrate and the heating tray being adjusted to be smaller than a set value m, where 0<m≤5mm.

23. The thin film deposition device of claim 1, 2, 7, 8, 9, 10, 11 or 12, wherein the heating tray is provided with a second through hole, when the substrate or the heating tray is rotated, the radio frequency source is kept in an on state, and the non-process gas is introduced into the gap between the substrate and the heating tray through the second through hole.

24. The thin film deposition device of claim 23, wherein the non-process gas is nitrogen or inert gas.

25. The thin film deposition device of claim 1, 2, 7, 8, 9, 10, 11 or 12, wherein when the substrate rotates or the heating tray rotates or the substrate and the heating tray rotates synchronously, the radio frequency source is kept in an on state and the radio frequency power is adjusted to smaller than it was during the thin film deposition process.

26. The thin film deposition device of claim 1, 2, 7, 8, 9, 10, 11 or 12,wherein before the substrate rotates or the heating tray rotates or the substrate and the heating tray rotates, the RF source is adjusted to be off and the processing chamber is purified..

27. A thin film deposition device, comprising:
a processing chamber configured for thin film deposition;
a gas supply assembly arranged on the top wall of the processing chamber for supplying process gas to the processing chamber;
a heating tray arranged below the gas supply assembly for bearing and heating a substrate;
a radio frequency source for providing radio frequency power to activate the process gas in the chamber to dissociate into plasma and deposit a thin film on the substrate;
a rotating mechanism connected to the gas supply assembly for driving the gas supply assembly to rotate.

28. A thin film deposition device, comprising:
a processing chamber configured for thin film deposition;
a gas supply assembly arranged on the top wall of the processing chamber for supplying process gas to the processing chamber;
a heating tray arranged below the gas supply assembly for bearing and heating a substrate;
a radio frequency source for providing radio frequency power to activate the process gas in the chamber to dissociate into plasma and deposit a thin film on the substrate;
a rotating mechanism connected to the heating tray for driving the heating tray to rotate around the center shaft of the substrate as the shaft of rotation to rotate the substrate synchronously;
when the rotating mechanism drives the heating tray to drive the substrate to rotate synchronously, the radio frequency source is adjusted to be off.

29. A thin film deposition device, comprising:
a processing chamber configured for thin film deposition;
a gas supply assembly arranged on the top wall of the processing chamber for supplying process gas to the processing chamber;
a heating tray arranged below the gas supply assembly for bearing and heating a substrate;
a radio frequency source for providing radio frequency power to activate the process gas in the chamber to dissociate into plasma and deposit a thin film on the substrate;
a supporting member for supporting the substrate;
a lifting member connected to the supporting member for driving the supporting member to rise or fall in the vertical direction to lift the substrate away from the heating tray or place the substrate on the heating tray;
a rotating mechanism connected to the heating tray for driving the heating tray to rotate around the center shaft of the substrate as the shaft of rotation to rotate the substrate synchronously;
when the rotating mechanism drives the heating tray to drive the substrate to rotate synchronously, the radio frequency source is adjusted to be off.

30. A thin film deposition apparatus, comprising:
a processing chamber configured for thin film deposition;
a gas supply assembly arranged on the top wall of the processing chamber for supplying process gas to the processing chamber;
a heating tray arranged below the gas supply assembly for bearing and heating a substrate;
a radio frequency source for providing radio frequency power to activate the process gas in the chamber to dissociate into plasma and deposit a thin film on the substrate;
a lifting member connected to the gas supply assembly for driving the gas supply assembly to rise or fall.

31. The thin film deposition device of claim 1, 2, 7, 8, 12 or 28, wherein after the thin film deposition is completed,(the substrate rotation times+1) *the setting angle of each time of substrate rotation=360°.

32. The thin film deposition device of claim 1, 2, 7, 8, 9, 10, 11, 12, 27, 28, 29 or 30, wherein the high frequency of the radio frequency source is n times of 13.56 MHz, where n=1, 2, 3, ..., 8.

33. The thin film deposition device of claim 1, 2, 7, 8, 9, 10, 11, 12, 27, 28, 29 or 30, wherein the range of the low frequency of the radio frequency source is 20KHz-400KHz.

34. A thin film deposition device, comprising:
a processing chamber configured for thin film deposition;
a gas supply assembly arranged on the top wall of the processing chamber for supplying process gas to the processing chamber;
a heating tray arranged below the gas supply assembly for bearing and heating a substrate;
a gas regulating unit arranged in the gas supply assembly having a second porous plate which is arranged opposite to the first porous plate of the gas supply assembly, the gap between the second porous plate and the first porous plate being adjustable.

35. The thin film deposition device of claim 34, wherein a side wall of the gas regulating unit can be stretched or shrunk in vertical direction to adjust the gap between the second porous plate and the first porous plate.

36. The thin film deposition device of claim 35, wherein the side wall of the gas regulating unit is a bellow that can be stretched downward or shrunk upward in vertical direction.

37. The thin film deposition device of claim 34, wherein the gas regulating unit includes a telescopic rod connected to the second porous plate, and the telescopic rod can be stretched or shrunk in vertical direction to adjust the gap between the second porous plate and the first porous plate.

38. A thin film deposition method, comprising:
S1, placing the substrate in the processing chamber and vacuuming the processing chamber;
S2, introducing process gas into the processing chamber and turning on the radio frequency source to deposit a certain number of layers of thin films on the substrate;
S3, stopping to introduce the process gas and introducing non-process gas to maintain the pressure in the processing chamber;
S4, keeping the radio frequency source in an on state, rotating the substrate or the heating tray or the substrate and the heating tray synchronously by a set angle;
S5, introducing process gas into the processing chamber again and re-depositing a certain number of layers of thin films on the substrate;
S6, stopping to introduce the process gas and introducing non-process gas to maintain the pressure in the processing chamber;
S7, determining whether the number of layers of the film deposited on the substrate meets the requirements; if not, going back to step S2; if yes, executing step S8;
S8, taking out the substrate from the processing chamber.

39. The thin film deposition method of claim 38, wherein the thin film deposited on the substrate comprises a first material and a second material alternately deposited alternately.

40. The thin film deposition method of claim 39, wherein the first material is silicon oxide, and the second material is silicon nitride.

41. The thin film deposition method of claim 38, after the thin film deposition is completed, (the substrate rotation times+1) *the setting angle of each time of the substrate rotation=360°.

42. A thin film deposition method, comprising:
S11, placing the substrate in the processing chamber and vacuuming the processing chamber;
S12, introducing the process gas into the processing chamber and turning on the radio frequency source to deposit a certain film thickness of thin film on the substrate;
S13, introducing the process gas, keeping the radio frequency source in an on state, rotating the substrate or the heating tray or the substrate and the heating tray synchronously by a set angle;
S14, depositing a thin film on the substrate;
S15, determining whether the thickness of the deposited film on the substrate meets the requirements, if not, going back to step S12; if yes, executing step S16;
S16, taking out the substrate from the processing chamber.

43. The thin film deposition method of claim 42, wherein (the substrate rotation times+1) *the setting angle of each time of the substrate rotation=360°, after the thin film deposition is completed.

44. The film deposition method of claim 38 or 42, wherein when the substrate or the heating tray is rotated, the radio frequency source is kept in an on state, and the gap between the substrate and the heating tray is adjusted to be smaller than a set value m, where 0<m≤5mm.

45. The film deposition method of claim 38 or 42,wherein when the substrate or the heating tray is rotated, the radio frequency source is kept in an on state and non-process gas is introduced into the gap between the substrate and the heating tray..

46. The thin film deposition method of claim 45, wherein the non-process gas is nitrogen or inert gas.

47. The film deposition method as claimed in claim 38 or 42, wherein when the substrate rotates or the heating tray rotates or the substrate and the heating tray rotate synchronously, the radio frequency source is kept in an on state and the radio frequency power is adjusted to be smaller than it was during the thin film deposition process.

48. The film deposition method of claim 38 or 42, wherein before the substrate rotation or the heating tray is rotation or the substrate and the heating tray synchronous rotation, the radio frequency source is adjusted to be off and the processing chamber is purified.

49. A thin film deposition method, comprising:
S21, placing the substrate in the processing chamber, and evacuating the processing chamber;
S22, introducing process gas into the processing chamber, and turning on the radio frequency source, depositing a certain number of layers of thin films on the substrate;
S23, stopping to introduce the process gas and introducing non-process gas to maintain the pressure in the processing chamber;
S24, adjusting the radio frequency source to be off, so that the heating tray drives the substrate to rotate synchronously by a set angle;
S25, introducing process gas into the processing chamber, and adjusting the radio frequency source to be on, and depositing a certain number of layers of thin films on the substrate;
S26, stopping to introduce the process gas and introducing non-process gas to maintain the pressure in the processing chamber;
S27, judging whether the number of layers of the film deposited on the substrate satisfies the set number of layers; if not, going back to step S22; if yes, executing step S28;
S28, taking out the substrate from the processing chamber.

50. The thin film deposition method of claim 49, wherein the thin film deposited on the substrate includes a first material and a second material alternately deposited.

51. The thin film deposition method of claim 50, wherein the first material is silicon oxide, and the second material is silicon nitride.

52. The thin film deposition method of claim 49, wherein after the thin film deposition is completed, wherein (the substrate rotation times+1) *the setting angle of each time of the substrate rotation=360°.

53. A thin film deposition method, comprising:
S31, placing the substrate in the processing chamber and evacuating the processing chamber;
S32, introducing process gas into the processing chamber, and turning on the radio frequency source, depositing a certain number of layers of thin films on the substrate;
S33, stopping to introduce the process gas into the processing chamber, and introducing non-process gas to maintain the pressure in the processing chamber;
S34, adjusting the radio frequency source to be off, lifting the substrate, driving the heating tray to rotate at a set angle, and then placing the substrate back on the heating tray;
S35, introducing process gas into the processing chamber, and adjusting the radio frequency source to be on, and depositing a certain number of layers of thin films on the substrate;
S36, stopping to introduce the process gas and introducing non-process gas to maintain the pressure in the processing chamber;
S37, judging whether the number of layers of the deposited thin film on the substrate satisfies the set number of layers; if not, going back to step S32; if yes, executing step S38;
S38, taking out the substrate from the processing chamber.

54. The thin film deposition method of claim 53, wherein the thin film deposited on the substrate includes a first material and a second material alternately deposited.

55. The thin film deposition method of claim 54, wherein the first material is silicon oxide, and the second material is silicon nitride.

56. A thin film deposition method, comprising:
S41, placing a multiple of substrates in sequence in the processing chamber to complete the thin film deposition process;
S42, rotating the gas supply assembly by a set angle;
S43, cleaning the processing chamber, and going back to S41 after the processing chamber is purified.

57. The thin film deposition method of claim 56, wherein the thin film deposited on the substrate includes a first material and a second material alternately deposited.

58. The thin film deposition method of claim 57, wherein the first material is silicon oxide, and the second material is silicon nitride.

59. A thin film deposition method, comprising:
S51, placing multiple substrates in sequence in the processing chamber to complete the thin film deposition process;
S52, adjusting the gap between a second porous plate of a gas regulating unit and a first porous plate of a gas supply assembly;
S53, cleaning the processing chamber, and after the processing chamber is purified going back to step S51.

60. The thin film deposition method of claim 59, wherein the gap between the second porous plate and the first porous plate is adjusted by stretching or shrinking the side wall of the gas regulating unit in vertical direction.

61. The thin film deposition method of claim 59, wherein the gap between the second porous plate and the first porous plate is adjusted by stretching or shrinking the telescopic rod in the gas regulating unit along the vertical direction.

62. The thin film deposition method of claim 59, wherein the thin film deposited on the substrate includes a first material and a second material deposited alternately.

63. The thin film deposition method of claim 62, wherein the first material is silicon oxide, and the second material is silicon nitride.

64. A thin film deposition device, comprising:
a processing chamber configured for thin film deposition;
a gas supply assembly arranged on the top wall of the processing chamber for supplying process gas to the processing chamber;
a heating tray arranged below the gas supply assembly for bearing and heating a substrate;
a radio frequency source for providing radio frequency power to activate the process gas in the chamber to dissociate into plasma and deposit a thin film on the substrate;
an ejector pin arranged in the heating tray, one end of the ejector pin beingarranged at the bottom of the processing chamber, the other end of the ejector pin being configured to receive the substrate;
wherein the processing chamber is provided with multiple heating trays and multiple sets of ejector pins, and the heights of the multiple sets of ejector pins are different.

65. The thin film deposition device of claim 1, 2, 7, 8, 9, 10, 11, 12, 27, 28 or 29, further comprising a controller respectively connected to the gas supply assembly, the heating tray, the radio frequency source, and the rotating member for controlling the gas supply assembly, the heating tray, the radio frequency source, and the rotating member to work.

66. A thin film deposition apparatus, comprising:
a substrate load port for placing substrates;
a buffer device;
a front-end robot configured to transfer the substrate between the substrate load port and the buffer device;
the thin film deposition device according to any one of claims 1-37 and 64 configured for thin film deposition on the substrate;
a process manipulator configured for transferring the substrate between the buffer device and the processing chamber of the thin film deposition device.

67. The thin film deposition apparatus of claim 66, wherein the thin film deposition device has multiple processing chambers, and the multiple processing chambers are symmetrically arranged on both sides of the process manipulator or sequentially arranged around the periphery of the process manipulator.

68. The thin film deposition apparatus of claim 67, wherein each processing chamber has multiple heating trays for film deposition on multiple substrates simultaneously.

69. The thin film deposition apparatus of claim 68, wherein the multiple heating trays in each processing chamber are arranged in a matrix.

70. The thin film deposition apparatus of claim 68, wherein the number of the heating trays in each processing chambers is three, and the three heating trays are arranged in a triangular

71. The thin film deposition apparatus of claim 66, wherein multiple substrates can be placed in the buffer device, and the centers of the multiple substrates are on the same circle, and the multiple substrates can be rotated along a rotation shaft perpendicular to the center of the circle to change the positions of the multiple substrates in the buffer device.

72. The thin film deposition apparatus of claim 66, wherein the buffer device includes at least two layers of rotating storage platforms, and one layer of the storage platform is configured to place the substrate to be deposited, and the other layer of the storage platform is configured to place the deposited substrate.

73. The thin film deposition apparatus of claim 72, wherein at least two buffer devices are arranged in the vertical direction.

74. The thin film deposition apparatus of claim 66, wherein the process manipulator is a telescopic rotating arm.

75. The thin film deposition apparatus of claim 66, wherein a non-contact magnetic levitation track is arranged below the process manipulator, and the process manipulator slides on the magnetic levitation track without oil and friction.

76. The thin film deposition apparatus of claim 70, wherein the process manipulator includes three substrate transfer arms for picking and placing substrates, and the positions and numbers of the substrate transfer arms are set corresponding to the multiple of heating trays.
